(19) Europäisches Patentamt
European Patent Office
Office européen des brevets

(11) EP 2 656 231 B1

(12) # EUROPÄISCHE PATENTSCHRIFT

(45) Veröffentlichungstag und Bekanntmachung des Hinweises auf die Patenterteilung:
**14.06.2017 Patentblatt 2017/24**

(21) Anmeldenummer: **11805831.2**

(22) Anmeldetag: **20.12.2011**

(51) Int Cl.:
***G06F 13/42*** *(2006.01)* ***H03K 19/0175*** *(2006.01)*
*G06F 3/16* *(2006.01)* *G06F 13/38* *(2006.01)*
*G06F 1/32* *(2006.01)*

(86) Internationale Anmeldenummer:
**PCT/EP2011/073432**

(87) Internationale Veröffentlichungsnummer:
**WO 2012/084966 (28.06.2012 Gazette 2012/26)**

(54) **EINGANGSSCHALTUNGSANORDNUNG**
INPUT CIRCUIT ARRANGEMENT
CIRCUIT D’ENTRÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.12.2010 DE 102010055618**

(43) Veröffentlichungstag der Anmeldung:
**30.10.2013 Patentblatt 2013/44**

(60) Teilanmeldung:
**17168964.9**

(73) Patentinhaber: **ams AG**
**8141 Premstätten (AT)**

(72) Erfinder:
- **FELLNER, Johannes**
  **A-8054 Pirka (AT)**
- **BÖHM, Michael**
  **A-8020 Graz (AT)**

(74) Vertreter: **Epping - Hermann - Fischer Patentanwaltsgesellschaft mbH**
**Schloßschmidstraße 5**
**80639 München (DE)**

(56) Entgegenhaltungen:
**US-A- 5 473 758**
**US-A1- 2003 200 359**
**US-A1- 2004 039 963**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 656 231 B1

## Beschreibung

Die vorliegende Erfindung betrifft eine Eingangsschaltungsanordnung.

Für einen Datenaustausch zwischen einer Eingangsschaltungsanordnung und einer Ausgangsschaltungsanordnung werden häufig ein Takteingang, ein Dateneingang und ein Datenausgang in der Eingangsschaltungsanordnung vorgesehen. Dazu werden mehrere Anschlussflächen auf einem Halbleiterkörper, welcher die Eingangsschaltungsanordnung aufweist, angeordnet. Der Dateneingang und der Datenausgang können auch eine gemeinsame Anschlussfläche verwenden wie etwa beim Inter-Integrated Circuit Bus, abgekürzt I2C-Bus.

Dokument DE 10 2006 042 115 A1 befasst sich mit einer Schaltungsanordnung, die eine Steuerschaltung und eine Speicherkette umfasst. Die Schaltungsanordnung umfasst einen ersten Eingang zur Zuführung eines Betriebsartsignals, einen zweiten Eingang zur Zuführung eines Taktsignals und einen bidirektionalen Anschluss für das Bereitstellen von Datensignalen.

Die Dokumente US 5,881,121, US 7,089,467 B2 und US 2006/0087307 A1 beschreiben eine Schnittstelle mit einem Anschluss, wobei ein Signal drei unterschiedliche Pegelwerte annehmen kann.

Dokument US 2004/0039963 A1 beschreibt eine asynchrone Debug-Schnittstelle. Dabei weist ein Eingangssignal einen logischen Wert 1 bei einem Versorgungsspannungswert und einen logischen Wert 0 bei einem Bezugsspannungswert auf. Das Eingangssignal wird zwei Komparatoren zugeleitet. Den Komparatoren nachgeschaltete Logikgatter generieren ein Datensignal und ein Taktsignal.

Dokument US 2003/0200359 A1 befasst sich mit einer seriellen Datenschnittstelle. Einer integrierten Schaltung wird an einem ersten Eingang ein Takt- und ein Resetsignal und an einem zweiten Eingang ein Datensignal zugeführt. Durch einen kurzen Impuls am ersten Eingang kann eine Betriebsart der integrierten Schaltung eingestellt werden.

Dokument US 5473758 A erläutert ein System mit Eingangs- und Ausgangsanschlüssen, das zwischen einem Programmiermodus und einem normalen Modus umschalten kann. Weiter umfasst das System ein serielles/paralleles Interface und einen Programmspeicher.

Aufgabe der vorliegenden Erfindung ist es, eine Eingangsschaltungsanordnung bereitzustellen, die eine hohe Vielseitigkeit und Flexibilität bei der Verwendung eines Anschlusses aufweist.

Diese Aufgabe wird mit dem Gegenstand des unabhängigen Anspruchs 1 gelöst. Weiterbildungen und Ausgestaltungen sind jeweils Gegenstand der abhängigen Ansprüche.

In einer Ausführungsform umfasst eine Eingangsschaltungsanordnung einen Anschluss und eine Erkennungsschaltung, die eingangsseitig mit dem Anschluss gekoppelt ist.

Die Eingangsschaltungsanordnung ist zum wahlweisen Betrieb in einer ersten und in einer zweiten Betriebsart ausgelegt. Der Anschluss dient zum Abgreifen eines Anschlusssignals. Die Erkennungsschaltung ist ausgelegt, die Eingangsschaltungsanordnung in eine Betriebsart aus einer Gruppe umfassend die erste und die zweite Betriebsart in Abhängigkeit von einer Steilheit einer Änderung des Anschlusssignals zu versetzen.

Mit Vorteil reicht die Detektion der Steilheit der Änderung des Anschlusssignals aus, um die Eingangsschaltungsanordnung alternierend in die erste und in die zweite Betriebsart zu versetzen. Das Versetzen in die erste oder die zweite Betriebsart erfolgt somit nicht durch zwei vorgegebene konstante Werte des Anschlusssignals. Mit Hilfe der Werte des Anschlusssignals können somit unabhängig von der Einstellung der Betriebsart weitere Informationen der Eingangsschaltungsanordnung zugeleitet werden. Somit ist der Anschluss vielseitig und flexibel verwendbar.

In einer Ausführungsform werden in der ersten Betriebsart über den Anschluss sowohl Daten- wie auch Taktinformationen der Eingangsschaltungsanordnung zugeführt. Die Eingangsschaltungsanordnung ist ausgelegt, in der zweiten Betriebsart ein Eingangssignal, das dem Anschlusssignal entspricht, bereitzustellen.

In einer Ausführungsform folgt das Eingangssignal dem Anschlusssignal in der zweiten Betriebsart. Das Eingangssignal ist während der ersten Betriebsart konstant und folgt nicht dem Anschlusssignal. Das Eingangssignal kann beispielsweise während der ersten Betriebsart den letzten Wert vor der Bestimmung der ersten Betriebsart beibehalten. Das Eingangssignal kann alternativ beispielsweise während der ersten Betriebsart konstant einen vorgegebenen logischen Wert aufweisen.

In einer Ausführungsform stellt die Erkennungsschaltung ein Taktsignal und ein Datensignal in Abhängigkeit von den während der ersten Betriebsart anliegenden Werten des Anschlusssignals an einem Taktausgang und an einem Datenanschluss bereit. Das Taktsignal und das Datensignal enthalten die über den Anschluss zugeführten Daten- und Taktinformationen. Hingegen stellt die Eingangsschaltungsanordnung das Eingangssignal in Abhängigkeit von den während der zweiten Betriebsart anliegenden Werten des Anschlusssignals an einem Pufferausgang bereit. Der Pufferausgang ist vom Taktausgang und vom Datenanschluss getrennt.

In einer Ausführungsform ist die Erkennungsschaltung ausgelegt, die Eingangsschaltungsanordnung in die erste Betriebsart zu versetzen, falls die Steilheit der Änderung des Anschlusssignals kleiner als ein vorgegebener Wert ist. Weiter ist die Erkennungsschaltung ausgelegt, die Eingangsschaltungsanordnung in die zweite Betriebsart zu versetzen, falls die Steilheit der Änderung des Anschlusssignals größer als der vorgegebene Wert ist. Je nach Geschwindigkeit der Änderung des Anschlusssignals wird somit die Eingangsschaltungsanordnung in die erste beziehungsweise in die zweite Betriebsart versetzt.

In einer Ausführungsform ist die Erkennungsschaltung ausgelegt, in Abhängigkeit von der Steilheit der ansteigenden Flanke des Anschlusssignals die Eingangsschaltungsanordnung in eine Betriebsart aus der Gruppe umfassend die erste und die zweite Betriebsart zu versetzen.

In einer bevorzugten Ausführungsform ist die Erkennungsschaltung ausgelegt, in Abhängigkeit von der Steilheit der fallenden Flanke des Anschlusssignals die Eingangsschaltungsanordnung in eine Betriebsart aus der Gruppe, umfassend die erste und die zweite Betriebsart, zu versetzen. Mit Vorteil wird somit ein eigener Anschluss zum Auswählen der Betriebsart vermieden. Die Steilheit der ansteigenden Flanke beeinflusst die Auswahl der Betriebsart nicht.

In einer Ausführungsform wird die erste Betriebsart mindestens während einer vorgegebenen Maximalzeitdauer beibehalten. Die Erkennungsschaltung umfasst dazu einen Zeitgeber und eine Erkennungslogik, die mit dem Anschluss und dem Zeitgeber gekoppelt ist. Der Zeitgeber ist als Oszillator ausgelegt. Der Zeitgeber dient zur Abgabe eines Pulssignals. Die Erkennungslogik kann ausgelegt sein, bei Erkennen der ersten Betriebsart den Zeitgeber zu triggern. Die Erkennungslogik zählt die Pulse des Pulssignals und bestimmt den Zeitpunkt, an dem die Maximalzeitdauer verstrichen ist. Dabei wird innerhalb der Maximalzeitdauer die erste Betriebsart beibehalten. Mit Vorteil wird während der Maximalzeitdauer die erste Betriebsart auch dann beibehalten, wenn die Steilheit der Änderung des Anschlusssignals größer als der vorgegebene Wert ist. Somit sind auch schnelle Pulse im Anschlusssignal in der ersten Betriebsart übertragbar. Während der vorgegebenen Maximalzeitdauer wird somit nicht von der ersten in die zweite Betriebsart gewechselt.

In einer Weiterbildung ist die Erkennungsschaltung ausgelegt dazu, die Eingangsschaltungsanordnung von der ersten Betriebsart in die zweite Betriebsart umzuschalten, auch wenn die Maximalzeitdauer noch nicht verstrichen ist, falls das Anschlusssignal eine Signalfolge aufweist, die von einer Menge vorgegebener Signalfolgen abweicht. Bei einer falschen Signalfolge wird mit Vorteil von der ersten in die zweite Betriebsart umgeschaltet. Somit wird vermieden, dass Störanteile oder Rauschen im Anschlusssignal als Daten interpretiert werden. Ein zufälliges Versetzen der Eingangsschaltungsanordnung in die erste Betriebsart hat somit keine Auswirkungen.

In einer Weiterbildung ist die Erkennungsschaltung ausgelegt dazu, in der ersten Betriebsart eine erste vorgegebene Signalfolge zu erkennen, mit der die Eingangsschaltungsanordnung dauerhaft in die erste Betriebsart geschaltet wird.

In einer Weiterbildung ist die Erkennungsschaltung ausgelegt dazu, in der ersten Betriebsart eine zweite vorgegebene Signalfolge zu erkennen, mit der die Eingangsschaltungsanordnung von der ersten in die zweite Betriebsart geschaltet wird.

In einer Weiterbildung ist die Erkennungsschaltung ausgelegt dazu, in der ersten Betriebsart eine dritte vorgegebene Signalfolge zu erkennen, mit der die Maximalzeitdauer außer Kraft gesetzt wird. Auch nach Ablauf der Maximalzeitdauer wird somit nicht von der ersten in die zweite Betriebsart gewechselt.

In einer Ausführungsform umfasst eine Eingangsschaltungsanordnung einen Anschluss sowie eine Auswerteschaltung. Der Anschluss dient zum Zuführen eines Anschlusssignals. Die Auswerteschaltung ist eingangsseitig mit dem Anschluss verbunden. Die Auswerteschaltung ist dazu implementiert, das Anschlusssignal in ein Datensignal und ein Taktsignal umzuwandeln. Dabei weist das Anschlusssignal Taktpulse auf, die von einem Referenzwert ausgehen sowie eine erste Höhe bei einem ersten logischen Wert des Datensignals und einen Zwischenpegel bei einem zweiten logischen Wert des Datensignals aufweisen. Der Zwischenpegel liegt zwischen der ersten Höhe und dem Referenzwert.

Mit Vorteil setzt sich das Anschlusssignal in einfacher Art und Weise aus dem Datensignal und dem Taktsignal zusammen. Somit werden über einen Anschluss Takt- und Dateninformationen der Eingangsschaltungsanordnung bereitgestellt und der Anschluss vielseitig verwendet.

Die erste Höhe kann den Wert einer Versorgungsspannung und der Referenzwert den Wert eines Bezugspotentials aufweisen. Alternativ kann die erste Höhe den Wert des Bezugspotentials und der Referenzwert den Wert der Versorgungsspannung aufweisen. Der Zwischenpegel kann ein Wert zwischen dem Wert der Versorgungsspannung und dem Wert des Bezugspotentials sein. In einer Ausführungsform erfüllen das Anschlusssignal, das Datensignal und das Taktsignal näherungsweise folgende Gleichung:

$$swi = KA \cdot clk \cdot (1 + KB \cdot din) ,$$

wobei swi der Spannungswert des Anschlusssignals, din der logische Wert des Datensignals, clk der logische Wert des Taktsignals sowie KA und KB Konstanten sind. Die Angabe näherungsweise kann beispielsweise ausdrücken, dass aufgrund der Verarbeitung des Anschlusssignals in der Auswerteschaltung Pulse des Taktsignals und des Datensignals eine Zeitverzögerung gegenüber Pulsen im Anschlusssignal aufweisen können.

In einer Ausführungsform umfasst die Eingangsschaltungsanordnung einen ersten und einen zweiten Vergleicher. Die Auswerteschaltung kann den ersten und den zweiten Vergleicher umfassen. Die Auswerteschaltung kann zusätzlich zum ersten und zweiten Vergleicher die Erkennungsschaltung umfassen. Der erste und der zweite Vergleicher sind eingangsseitig mit dem Anschluss und ausgangsseitig mit der Erkennungsschaltung verbunden. Der erste Vergleicher vergleicht das Anschlusssignal oder ein vom Anschlusssignal abgeleitetes Signal mit einem ersten vorgegebenen Schwellwert und stellt in Abhängigkeit von dem Vergleichsergebnis ein erstes Vergleichersignal der Erkennungsschaltung bereit. Weiter vergleicht der zweite Vergleicher das Anschlusssignal oder das vom Anschlusssignal abgeleitete Signal mit einem zweiten vorgegebenen Schwellwert. Der erste vorgegebene Schwellwert unterscheidet sich vom zweiten vorgegebenen Schwellwert. In Abhängigkeit von dem Vergleichsergebnis stellt der zweite Vergleicher ein zweites Vergleichersignal der Erkennungsschaltung bereit. Der erste und der zweite Vergleicher dienen zur Aufspaltung des Anschlusssignals in ein Takt- und ein Datensignal. Die Vergleicher können als Komparatoren ausgebildet sein.

In einer Ausführungsform ist die Erkennungsschaltung ausgelegt, in der ersten Betriebsart das erste und das zweite Vergleichersignal auszuwerten. Dabei stellt die Erkennungsschaltung ein Taktsignal in Abhängigkeit von dem ersten und dem zweiten Vergleichersignal bereit. Weiter stellt die Erkennungsschaltung ein Datensignal in Abhängigkeit von dem ersten und dem zweiten Vergleichersignal bereit.

In einer Weiterbildung generiert die Erkennungsschaltung das Taktsignal ausschließlich in Abhängigkeit vom ersten Vergleichersignal. Das zweite Vergleichersignal wird zur Erzeugung des Taktsignals nicht herangezogen.

In einer Weiterbildung erzeugt die Erkennungsschaltung das Datensignal ausschließlich in Abhängigkeit vom zweiten Vergleichersignal. Das erste Vergleichersignal wird dabei nicht zur Generierung des Datensignals verwendet. Somit werden das Takt- und das Datensignal sehr effizient generiert. Der erste und der zweite Vergleicher ermöglichen eine effektive Wandlung des Anschlusssignals, das drei Signalpegel aufweisen kann, in das Datensignal und das Taktsignal.

In einer Ausführungsform ist die Eingangsschaltungsanordnung ausgelegt, das Anschlusssignal in Abhängigkeit von einem Datenausgangssignal zu beeinflussen. Somit kann die Eingangsschaltungsanordnung Daten an den Anschluss abgeben. Die Eingangsschaltungsanordnung kann somit nicht nur Empfänger von Daten, sondern auch Sender von Daten sein. Die Eingangsschaltungsanordnung kann dazu einen Signalkonverter aufweisen, der mit dem Anschluss verbunden ist. Somit ist der Anschluss in vielfältiger Weise verwendbar.

In einer Ausführungsform verwirklicht die Eingangsschaltungsanordnung somit das Prinzip einer seriellen Eindraht-Schnittstelle mit Aktivierung.

In einer Ausführungsform werden in der ersten Betriebsart über den Anschluss sowohl Daten- wie auch Taktinformationen der Eingangsschaltungsanordnung zugeführt. Die zweite Betriebsart kann zum Zuführen eines Aktivierungssignals über den Anschluss an die Eingangsschaltungsanordnung vorgesehen sein.

In einer Weiterbildung weist die Eingangsschaltungsanordnung eine dritte Betriebsart auf, in der sich die Eingangsschaltungsanordnung in einem Testmodus befindet. Die Eingangsschaltungsanordnung wechselt von der ersten in die dritte Betriebsart dadurch, dass die Erkennungsschaltung ausgelegt ist, in der ersten Betriebsart eine vierte vorgegebene Signalfolge zu erkennen.

In einer Ausführungsform ist die Erkennungsschaltung ausgelegt, die Eingangsschaltungsanordnung in die erste Betriebsart zu versetzen, wenn die fallende Flanke des Anschlusssignals die Stufe mit dem Wert des Zwischenpegels aufweist. Weiter kann die Erkennungsschaltung ausgelegt sein, die Eingangsschaltungsanordnung in die zweite Betriebsart zu versetzen, wenn die fallende Flanke des Anschlusssignals ohne eine auf dem Wert des Zwischenpegels liegende Stufe ist. Die fallende Flanke kann der Übergang des Anschlusssignals von einer Versorgungsspannung auf ein Bezugspotential sein.

In einer Ausführungsform umfasst eine Ausgangsschaltungsanordnung einen Ausgangsanschluss, einen Taktanschluss, einen Dateneingang sowie eine Anordnung zum Erzeugen eines Zwischenpegels. Der Ausgangsanschluss ist zum Abgeben eines Anschlusssignals geeignet. Der Taktanschluss ist zum Zuführen eines Taktanschlusssignals ausgelegt. Die Anordnung zum Erzeugen eines Zwischenpegels ist eingangseitig mit dem Taktanschluss und dem Dateneingang und ausgangseitig mit dem Ausgangsanschluss verbunden. Die Anordnung zum Erzeugen eines Zwischenpegels ist ausgelegt, das Dateneingangssignal und das Taktanschlusssignal derart in das Anschlusssignal zu wandeln, dass das Anschlusssignal Taktpulse aufweist, die von einem Referenzwert ausgehen sowie eine erste Höhe bei einem ersten logischen Wert des Dateneingangssignals und einen Zwischenpegel bei einem zweiten logischen Wert des Dateneingangssignals aufweisen. Der Zwischenpegel weist einen Wert zwischen der ersten Höhe und dem Referenzwert auf.

Mit Vorteil kann die Ausgangsschaltungsanordnung das Anschlusssignal aus dem Taktanschlusssignal und dem Dateneingangssignal erzeugen.

In einer Ausführungsform umfasst die Anordnung zum Erzeugen eines Zwischenpegels einen Spannungsteiler. Ein Spannungsteilerabgriff ist mit dem Ausgangsanschluss verbunden. Ein erster äußerer Anschluss des Spannungsteilers ist an den Taktanschluss angeschlossen. Ein zweiter äußerer Anschluss des Spannungsteilers wird bei einem ersten logischen Wert des Dateneingangssignals mit einem Bezugspotentialanschluss verbunden. Bei einem zweiten logischen Wert des Dateneingangssignals wird der zweite äußere Anschluss des Spannungsteilers offen geschaltet oder mit einem Versorgungsspannungsanschluss verbunden. Der Spannungsteiler ermöglicht eine kosteneffektive und flexible Erzeugung der drei Signalpegel des Anschlusssignals.

In einer Ausführungsform wird mittels des Taktanschlusssignals der Ausgangsanschluss auf den Wert der Versorgungsspannung gelegt. Anschließend steuert das Dateneingangssignal die Anordnung zum Erzeugen eines Zwischenpegels derart an, dass die Spannung des Anschlusssignals verringert wird. Darauf legt das Taktsignal den Ausgangsanschluss auf den Wert des Bezugspotentials. Der Abfall des Anschlusssignals erfolgt somit mit einer Stufe. Durch die Wahl des Taktanschlusssignals und des Dateneingangssignals kann folglich die Steilheit einer Änderung des Anschlusssignals eingestellt werden. Die Ausgangsschaltungsanordnung versetzt dadurch die Eingangsschaltungsanordnung wahlweise in die erste oder die zweite Betriebsart.

In einer Ausführungsform umfasst ein System die Eingangsschaltungsanordnung sowie die Ausgangsschaltungsanordnung. Dabei ist der Ausgangsanschluss der Ausgangsschaltungsanordnung mit dem Anschluss der Eingangsschaltungsanordnung gekoppelt. Das Anschlusssignal des Ausgangsanschlusses der Ausgangsschaltungsanordnung ist näherungsweise gleich dem Anschlusssignal am Anschluss der Eingangsschaltungsanordnung.

Mit Vorteil ist sowohl die Zuführung von Daten wie auch eines Taktes von der Ausgangsschaltungsanordnung an die Eingangsschaltungsanordnung über eine einzige, an dem Ausgangsanschluss angeschlossene Anschlussfläche der Ausgangsschaltungsanordnung wie auch über eine einzige, an dem Anschluss angeschlossene Anschlussfläche der Eingangsschaltungsanordnung ermöglicht. Durch die niedrige Anzahl von Verbindungen zwischen der Ausgangs- und der Eingangsschaltungsanordnung wird eine Fläche auf einem Träger gering gehalten. Weiter lässt sich ein derartiges System kostengünstig realisieren.

Das System ermöglicht es, Takt- und Dateninformationen zu verknüpfen und nach der Übertragung wieder aufzutrennen.

In einer Ausführungsform wird das System realisiert und die Eingangsschaltungsanordnung in die erste Betriebsart versetzt. Die Eingangsschaltungsanordnung ist dabei lösbar mit der Ausgangsschaltungsanordnung verbunden. So kann beispielsweise die Eingangsschaltungsanordnung vom Hersteller programmiert oder kalibriert werden. Anschließend wird die Eingangsschaltungsanordnung in ein Anwendungssystem eingesetzt. Die Verbindung der Eingangsschaltungsanordnung mit dem Anwendungssystem kann permanent und nicht lösbar sein. Die Eingangsschaltungsanordnung wird nach dem Einsetzen in das Anwendungssystem in die zweite Betriebsart versetzt.

In einer weiteren Ausführungsform kann die Ausgangsschaltungsanordnung mit diskreten Bauteilen aufgebaut werden und somit einfach für den Laborbetrieb realisiert werden.

In einer weiteren Ausführungsform kann die Ausgangsschaltungsanordnung durch einen Signalgenerator realisiert werden, wie er für professionelle Testersysteme zur Verfügung steht.

Die Erfindung wird nachfolgend an mehreren Ausführungsbeispielen anhand der Figuren näher erläutert. Funktions- beziehungsweise wirkungsgleiche Bau- und Schaltungselemente tragen gleiche Bezugszeichen. Insoweit sich Schaltungsteile oder Bauelemente in ihrer Funktion entsprechen, wird deren Beschreibung nicht in jeder der folgenden Figuren wiederholt.

Es zeigen:

Figuren 1A und 1B beispielhafte Ausführungsformen eines Systems nach dem vorgeschlagenen Prinzip,

Figuren 2A und 2B beispielhafte Signalverläufe eines Systems nach dem vorgeschlagenen Prinzip und

Figur 3 eine beispielhafte Ausführungsform eines Systems in räumlicher Darstellung nach dem vorgeschlagenen Prinzip.

Figur 1A zeigt eine beispielhafte Ausführungsform eines Systems 10 nach dem vorgeschlagenen Prinzip. Das System 10 weist eine Eingangsschaltungsanordnung 11 und eine Ausgangsschaltungsanordnung 12 auf. Die Eingangsschaltungsanordnung 11 umfasst einen Anschluss 13 und eine Auswerteschaltung 16, die eingangsseitig mit dem Anschluss 13 verbunden ist. Die Eingangsschaltungsanordnung 11 weist eine Anschlussfläche 15 auf, an die der Anschluss 13 angeschlossen ist. Die Auswerteschaltung 16 umfasst eine Erkennungsschaltung 14. Die Erkennungsschaltung 14 ist mit dem Anschluss 13 gekoppelt.

Die Auswerteschaltung 16 umfasst einen ersten und einen zweiten Vergleicher 17, 18, die beide eingangsseitig mit dem Anschluss 13 verbunden sind. Ein Ausgang des ersten Vergleichers 17 und ein Ausgang des zweiten Vergleichers 18 sind mit der Erkennungsschaltung 14 verbunden. Die Erkennungsschaltung 14 umfasst einen Taktausgang 19 und einen Datenanschluss 20. Die Erkennungsschaltung 14 koppelt den Taktausgang 19 mit dem Ausgang des ersten Vergleichers 17 und dem Ausgang des zweiten Vergleichers 18. Weiter koppelt die Erkennungsschaltung 14 den Datenanschluss 20 mit dem Ausgang des ersten Vergleichers 17 und dem Ausgang des zweiten Vergleichers 18. Dazu verbindet die Erkennungsschaltung 14 den Taktausgang 19 mit dem Ausgang des ersten Vergleichers 17. Der Taktausgang 19 ist direkt und permanent an den Ausgang des ersten Vergleichers 17 angeschlossen.

Weiter umfasst die Erkennungsschaltung 14 einen Zeitgeber 21 sowie eine Erkennungslogik 22. Ein Ausgang der Erkennungslogik 22 ist mit einem Eingang des Zeitgebers 21 sowie ein Eingang der Erkennungslogik 22 ist mit einem Ausgang des Zeitgebers 21 verbunden. Weitere Eingänge der Erkennungslogik 22 sind an den Ausgang des ersten Vergleichers 17 und an den Ausgang des zweiten Vergleichers 18 angeschlossen. Der Datenanschluss 20 ist mit einem Ausgang der Erkennungslogik 22 verbunden. Die Erkennungslogik 22 ist als Digitalschaltung realisiert und umfasst Logikgatter. Die Erkennungslogik 22 umfasst einen Zähler. Der Zähler kann eine Kette von FlipFlops aufweisen.

Darüber hinaus umfasst die Eingangsschaltungsanordnung 11 einen Signalzwischenspeicher 23, der mit dem Anschluss 13 verbunden ist. Der Signalzwischenspeicher 23 weist einen Pufferausgang 24 auf. Die Erkennungsschaltung 14 umfasst einen Betriebsartausgang 25, die mit einem Steuereingang des Signalzwischenspeichers 23 verbunden ist. Der Betriebsartausgang 25 ist an die Erkennungslogik 22 angeschlossen. Der Signalzwischenspeicher 23 ist als Speicher realisiert. Der Signalzwischenspeicher 23 umfasst einen Puffer 36, der eingangsseitig an den Anschluss 13 und ausgangsseitig an den Pufferausgang 24 angeschlossen ist. Der Puffer 36 weist eine Signalhaltefunktion auf. Ein Steuereingang des Puffers 36 ist mit dem Betriebsartausgang 25 gekoppelt. Weiter weist der Signalzwischenspeicher 23 einen weiteren Puffer 37 mit einem Eingang auf, der mit einem Ausgangsanschluss 26 verbunden ist. Ein Steuereingang des weiteren Puffers 36 ist mit einer Ausgangsaktivschaltung 39 verbunden. Der weitere Puffer 37 weist einen Tristate-Ausgang auf. Ausgangsseitig ist der weitere Puffer 37 mit dem Anschluss 13 verbunden. Der Signalzwischenspeicher 23 weist somit den Puffer 36 und den weitere Puffer 37 auf, die antiparallel geschaltet sind.

Weiter weist die Eingangsschaltungsanordnung 11 einen Signalkonverter 27 auf, welcher ausgangsseitig an den Anschluss 13 angeschlossen ist. Der Signalkonverter 27 koppelt den Anschluss 13 mit einem Bezugspotenzialanschluss 28. Der Signalkonverter 27 weist ein resistives Element 29 auf, welches im Strompfad zwischen dem Anschluss 13 und dem Bezugspotenzialanschluss 28 angeordnet ist. Das resistive Element 29 ist als Widerstand implementiert. Darüber hinaus umfasst der Signalkonverter 27 einen Schalter 30, der seriell zum resistiven Element 29 geschaltet ist. Die Serienschaltung umfassend den Schalter 30 und das resistive Element 29 verbindet den Anschluss 13 mit dem Bezugspotenzialanschluss 28. Dabei ist das resistive Element 29 an den Anschluss 13 und der Schalter 30 an den Bezugspotenzialanschluss 28 angeschlossen. Das resistive Element 29 kann einen Widerstandswert aus einem Bereich zwischen 1 Ohm bis 10 MOhm aufweisen. Bevorzugt weist das resistive Element 29 einen Widerstandswert aus einem Bereich zwischen 100 Ohm und 1 MOhm auf. Weiter bevorzugt weist das resistive Element 29 einen Widerstandswert aus einem Bereich zwischen 1 kOhm und 100 kOhm auf. Der Widerstandswert des resistiven Elements 29 beträgt beispielsweise 10 kOhm.

Darüber hinaus umfasst die Eingangsschaltungsanordnung 11 einen Datenausgang 31, der mit einem Steueranschluss des Signalkonverters 27 verbunden ist. Dazu ist der Datenausgang 31 an den Steueranschluss des Schalters 30 angeschlossen. Weiter umfasst die Eingangsschaltungsanordnung 11 einen Schaltungsblock 32. Der Schaltungsblock 32 ist an den Taktausgang 19, den Datenanschluss 20 und den Datenausgang 31 angeschlossen. Der Schaltungsblock 32 kann eine Digitalschaltung mit seriellem Interface sein. Die Eingangsschaltungsanordnung 11 umfasst einen weiteren Schaltungsblock 33, der an den Pufferausgang 24 angeschlossen ist.

Die Ausgangsschaltungsanordnung 12 weist einen Ausgangsanschluss 40 auf. Der Ausgangsanschluss 40 ist mit dem Anschluss 13 gekoppelt. Der Ausgangsanschluss 40 ist an eine weitere Anschlussfläche 41 der Ausgangsschaltungsanordnung 12 angeschlossen. Die weitere Anschlussfläche 41 ist mit der Anschlussfläche 15 der Eingangsschaltungsanordnung 11 gekoppelt. Der Ausgangsanschluss 40 ist direkt und permanent an den Anschluss 13 angeschlossen. Die Ausgangsschaltungsanordnung 12 umfasst eine Anordnung zum Erzeugen eines Zwischenpegels 55. Die Anordnung zum Erzeugen eines Zwischenpegels 55 weist einen Spannungsteiler 44 mit einem ersten und einem zweiten Spannungsteilerwiderstand 43, 46 auf. Der erste und der zweite Spannungsteilerwiderstand 43, 46 weisen jeweils einen Widerstandswert auf, der näherungsweise dem Widerstandswert des resistiven Elements 29 entspricht.

Die Ausgangsschaltungsanordnung 12 umfasst darüber hinaus einen Taktanschluss 42 und einen Dateneingang 45, welche mit der Anordnung 55 zum Erzeugen eines Zwischenpegels SZ gekoppelt sind. Der Taktanschluss 42 ist über den ersten Spannungsteilerwiderstand 43 mit dem Ausgangsanschluss 40 verbunden. Der Ausgangsanschluss 40 ist über den zweiten Spannungsteilerwiderstand 46 und einen Ausgangsschalter 47 mit dem Bezugspotentialanschluss 28 verbunden. Der Steueranschluss des Ausgangsschalters 47 ist mit dem Dateneingang 45 gekoppelt. Dabei ist der zweite Spannungsteilerwiderstand 46 an den Ausgangsanschluss 41 und der Ausgangsschalter 47 an den Bezugspotenzialanschluss 28 angeschlossen.

Ferner weist die Ausgangsschaltungsanordnung 12 einen Komparator 49 auf, der an einem ersten Eingang mit dem Ausgangsanschluss 40 verbunden ist. Der Komparator 49 ist zum digitalen Auslesen vorgesehen. Sein Referenzpegel wird beispielsweise zwischen VDD und VDD/2 über einen Referenzspannungsteiler 50 eingestellt. Der Referenzpegel des Komparators 49 ist höher als der Zwischenpegel SZ. Der Referenzspannungsteiler 50 verbindet den Taktanschluss 42 mit dem Bezugspotenzialanschluss 28. Alternativ verbindet der Referenzspannungsteiler 50 den Versorgungsspannungsanschluss 34 mit dem Bezugspotenzialanschluss 28. Der Referenzspannungsteiler 50 umfasst einen ersten und einen zweiten Vergleichswiderstand 51, 52. Ein Knoten zwischen dem ersten und dem zweiten Vergleichswiderstand 51, 52 ist mit einem zweiten Eingang des Komparators 49 verbunden. Der erste Vergleichswiderstand 51 verbindet den zweiten Eingang des Komparators 49 mit dem Takteingang 42. Der zweite Vergleichswiderstand 52 verbindet den zweiten Eingang des Komparators 49 mit dem Bezugspotenzialanschluss 28.

Der Widerstandswert des zweiten Vergleichswiderstands 52 ist größer als der Widerstandswert des ersten Vergleichswiderstands 51. In einem Beispiel beträgt der Widerstandswert des zweiten Vergleichswiderstands 52 das Doppelte des Widerstandswerts des ersten Vergleichswiderstands 51. Der Widerstandswert des Vergleichswiderstands 51 ist in einer Ausführungsform 10 kOhm und der Widerstandswert des zweiten Vergleichswiderstands 52 beträgt 20 kOhm. Ein Datenausgang 53 ist an den Ausgang des Komparators 40 angeschlossen. Darüber hinaus umfasst die Ausgangsschaltungsanordnung 12 einen Schnittstellensteuerungsblock 54, der an den Taktanschluss 42, den Dateneingang 45 und den Datenausgang 53 angeschlossen ist. Der Schnittstellensteuerungsblock 54 weist einen Signalgenerator auf. Der Schnittstellensteuerungsblock 54 kann als Mikrokontroller realisiert sein. Der Schnittstellensteuerungsblock 54 kann auch als Personal Computer implementiert sein, der über eine digitale Schnittstelle mit den weiteren Teilen der Ausgangsschaltungsanordnung 12 gekoppelt ist.

Am Anschluss 13 ist das Anschlusssignal SWI abgreifbar. Das Anschlusssignal SWI wird dem ersten und dem zweiten Vergleicher 17, 18 zugeleitet. Der erste und der zweite Vergleicher 17, 18 generieren ein erstes und ein zweites Vergleichersignal SK1, SK2 in Abhängigkeit von dem Anschlusssignal SWI und dem ersten Schwellwert SREF1 des ersten Vergleichers 17 und dem zweiten Schwellwert SREF2 des zweiten Vergleichers 18. Dabei ist der erste Schwellwert SREF1 kleiner als der zweite Schwellwert SREF2. An einem Versorgungsspannungsanschluss 34 der Eingangsspannungsanordnung 11 ist eine Versorgungsspannung VDD abgreifbar. Am Bezugspotenzialanschluss 28 ist ein Bezugspotenzial VSS abgreifbar. Der Zwischenpegel SZ teilt den Bereich zwischen der Versorgungsspannung VDD und dem Bezugspotenzial VSS in zwei Bereiche, so dass gilt:

$$VSS < SREF1 < SZ < SREF2 < VDD \quad ,$$

wobei SZ der Wert des Zwischenpegels, SREF1 der Wert der ersten Schwellwerts, SREF2 der Wert des zweiten Schwellwerts, VDD der Wert der Versorgungsspannung und VSS der Wert des Bezugspotenzials ist. Bevorzugt hat der Zwischenpegel SZ den Wert der Hälfte der Versorgungsspannung VDD, so dass SZ = VDD/2 gilt. Der erste und der zweite Vergleicher 17, 18 können als Komparatoren oder Buffer mit verstellbarer Schaltschwelle ausgeführt werden. Der erste Schwellwert SREF1 des ersten Vergleichers 17 liegt bevorzugt zwischen dem Bezugspotential VSS und VDD/2, der zweite Schwellwert SREF2 des zweiten Vergleichers 18 liegt bevorzugt zwischen VDD/2 und Versorgungsspannung VDD.

Ein Taktsignal CLK ist am Taktausgang 19 abgreifbar. Ein Datensignal DIN ist an dem Datenanschluss 20 abgreifbar. Das Taktsignal CLK kann identisch mit dem ersten Vergleichersignal SK1 sein. Das Datensignal DIN kann in einer Ausführungsform identisch mit dem zweiten Vergleichersignal SK2 sein. Die Erkennungslogik 22 ist derart realisiert, dass die vom Datensignal DIN bereitgestellten Daten auf die fallende Flanke des Taktsignals CLK übernommen werden. Das Datensignal DIN wird daher derart in der Erkennungslogik 22 gebildet, dass die steigenden Flanken des Datensignals DIN und des Taktsignals CLK übereinander fallen und die fallenden Flanken des Datensignals DIN und des Taktsignals CLK übereinstimmt.

Der Zeitgeber 21 gibt ein Pulssignal ST ab. Die Frequenz des Pulssignals ST kann höher als die Frequenz des Taktsignals CLK sein. Der Zeitgeber 21 wird in der ersten Betriebsart A aktiviert und in der zweiten Betriebsart B deaktiviert. Weiter ist die Erkennungsschaltung 14 derart realisiert, dass sie aus den Werten des ersten und des zweiten Vergleichersignals SK1, SK2 ermittelt, ob die Eingangsschaltungsanordnung 11 in die erste oder in die zweite Betriebsart A, B einzustellen ist. Dazu wertet die Erkennungslogik 22 das erste und das zweite Vergleichersignal SK1, SK2 derart aus, dass bei einer hohen Steilheit einer Änderung des Anschlusssignals SWI die zweite Betriebsart B und bei einer geringen Steilheit der Änderung des Anschlusssignals SWI die erste Betriebsart A eingestellt wird. Die Erkennungslogik 22 ist dazu ausgebildet, die Betriebsart in Abhängigkeit der fallenden Flanke des Anschlusssignals SWI zu bestimmen. Dazu untersucht die Erkennungslogik 22 bei einer fallenden Flanke des Anschlusssignals SWI, ob der zeitliche Unterschied zwischen der Flanke im ersten Vergleichersignal SK1 und der Flanke im zweiten Vergleichersignal kleiner als ein vorgegebener Wert ist, so dass die zweite Betriebsart B einzustellen ist, oder der zeitliche Unterschied größer als der vorgegebene Wert ist, so dass die erste Betriebsart A einzustellen ist. Die Erkennungslogik 22 bestimmt den zeitlichen Unterschied durch Zählen der Pulse des Pulsignals ST zwischen der fallenden Flanke des zweiten Vergleichersignals SK2 und der fallenden Flanke des ersten Vergleichersignals SK1.

Die Erkennungslogik 22 stellt am Betriebsartausgang 25 ein Betriebsartsignal SB bereit, das einen ersten Wert im Falle der ersten Betriebsart A und einen zweiten Wert im Falle der zweiten Betriebsart B aufweist. Wird die erste Betriebsart A erkannt, so wird das erste Vergleichersignal SK1 von der Erkennungsschaltung 14 durchgeleitet und bildet das Taktsignal CLK und wird ebenfalls das zweite Vergleichersignal SK2 von der Erkennungsschaltung 14 durchgeleitet und bildet das Datensignal DIN. Ist die zweite Betriebsart B erkannt, so wird das Taktsignal CLK generiert und entspricht dem ersten Vergleichersignal SK1. Das Datensignal DIN hingegen weist in einer Ausführungsform einen konstanten Wert auf.

Das Betriebsartsignal SB wird dem Signalzwischenspeicher 23 zugeleitet. Der Signalzwischenspeicher 23 gibt am Pufferausgang 24 ein Eingangssignal SE ab. Der Signalzwischenspeicher 23 speichert den letzten Wert des Eingangssignals SE bei einem Wechsel in ein andere Betriebsart zwischen. Der Puffer 36 erzeugt das Eingangssignal SE in Abhängigkeit von dem Anschlusssignal SIW und dem Betriebsartsignal SB. Der Signalzwischenspeicher 23 ist derart implementiert, dass er in der zweiten Betriebsart B das Anschlusssignal SWI als Eingangssignal SE bereitstellt. Das Eingangssignal SE folgt dem Anschlusssignal SWI in der zweiten Betriebsart B. Wird jedoch von der Erkennungsschaltung 14 die erste Betriebsart A bestimmt, so behält das Eingangssignal SE den letzten Wert vor der Bestimmung der ersten Betriebsart A bei. Während der Dauer der ersten Betriebsart A ist jedoch das Eingangssignal SE konstant und weist beispielsweise den logischen Wert 1 auf sowie folgt nicht dem Anschlusssignal SWI. Das Eingangssignal SE kann somit als Enable-Signal realisiert sein. Das Eingangssignal SE ist ein Ausgangssignal des Signalzwischenspeichers 23. Die normale Funktion des Anschlusses 13 und der Anschlussfläche 15 wird von dem Signalzwischenspeicher 23 repräsentiert. Das Eingangssignal SE wird auf einen definierten Pegel festgelegt, sobald eine gültige Aktivierungssequenz den Anschluss 13 für die Schnittstellenfunktion aktiviert, das heißt die Eingangsschaltungsanordnung 11 in die erste Betriebsart A versetzt. Der Signalzwischenspeicher 23 ist bidirektional implementiert. Ein am Ausgangsanschluss 26 anliegendes Schaltungsausgangssignal SO wird dem Eingang des weiteren Puffers 37 zugeleitet. Ein Ausgangsaktivschaltungssignal SOEN liegt am Steuereingang des weiteren Puffers 37 an. Der weitere Puffer 37 stellt an seinem Ausgang das Anschlusssignal SWI in Abhängigkeit von dem Schaltungsausgangssignal SO und dem Ausgangsaktivschaltungssignal SOEN bereit. Somit kann der Signalzwischenspeicher 23 für die Signalübertragung vom weiteren Schaltungsblock 33 zum Anschluss 13 eingesetzt werden.

Am Datenausgang 31 liegt ein invertiertes Ausgangssignal DOUTN an. Das invertierte Ausgangssignal DOUTN wird dem Signalkonverter 27 zugeleitet. Entsprechend dem invertierten Ausgangssignal DOUTN wird der Schalter 30 in einen offenen oder in einen geschlossenen Betriebszustand versetzt. Dadurch wird das Anschlusssignal SWI beeinflusst und somit eine Information an den Anschluss 13 abgegeben. Schaltet beispielsweise das invertierte Ausgangssignal DOUTN den Schalter 30 in einen offenen Betriebszustand, so nimmt das Anschlusssignal SWI einen von der Ausgangsschaltungsanordnung 12 vorgegebenen Spannungswert an. Schaltet hingegen das invertierte Ausgangssignal DOUTN den Schalter 30 in einen leitenden Betriebszustand, so ist der Anschluss 13 über das resistive Element 29 mit dem Bezugspotenzialanschluss 28 verbunden und das Anschlusssignal SWI wird auf den Wert des Zwischenpegels SZ verringert oder behält den Wert des Bezugspotenzials VSS bei.

An dem Taktanschluss 42 liegt ein Taktanschlusssignal CLKA an. Weiter liegt am Datenausgang 53 ein Datenausgangssignal DOUTA an. Entsprechend wird dem Dateneingang 45 ein Dateneingangssignal DINA zugeleitet. Das Taktanschlusssignal CLKA wird über den ersten Spannungsteilerwiderstand 43 dem Ausgangsanschluss 40 zugeführt. Der Ausgangsschalter 47 wird vom Dateneingangsignal DINA gesteuert und überträgt ein digitales HIGH oder LOW an den Ausgangsanschluss 41. Mit dem Dateneingangssignal DINA wird eingestellt, ob der Ausgangsanschluss 40 über den zweiten Spannungsteilerwiderstand 46 mit dem Bezugspotenzialanschluss 28 leitend verbunden wird oder das Anschlusssignal SWI nicht durch einen Stromfluss durch den zweiten Spannungsteilerwiderstand 46 reduziert wird. Hat beispielsweise das Dateneingangssignal DINA den logischen Wert 1, so ist der Ausgangschalter 47 in einem offenen Betriebszustand und das Anschlusssignal SWI wird vor allem vom Taktanschlusssignal CLKA bestimmt. Das Taktanschlusssignal CLKA kann Werte zwischen der Versorgungsspannung VDD und dem Bezugspotenzial VSS annehmen. Das Anschlusssignal SWI nimmt somit bei einem logischen Wert 1 des Taktanschlusssignals CLK den Wert der Versorgungsspannung VDD und im Falle des logischen Werts 0 des Taktanschlusssignals CLKA das Bezugspotenzial VSS an.

Nimmt das Dateneingangssignal DINA den logischen Wert 0 an, so ist der Ausgangsschalter 47 leitend geschaltet. Ein logischer Wert 0 im Taktanschlusssignal CLK führt somit zu einem Anschlusssignal SWI, welches den Wert des Bezugspotenzials VSS aufweist. Im Fall eines logischen Wert 1 des Taktanschlusssignals CLKA hingegen nimmt das Anschlusssignal SWI den Zwischenpegel SZ als Spannungswert an, der von den Widerstandswerten des ersten und des zweiten Spannungsteilerwiderstands 43, 46 abhängt. Der Wert des Zwischenpegels SZ lässt sich somit gemäß folgender Gleichung berechnen:

$$SZ = \frac{R1B}{R1B + R1A} \cdot VDD ,$$

wobei VDD der Wert der Versorgungsspannung, R1A der Widerstandswert des ersten Spannungsteilerwiderstands 43, R1B die Summe des Widerstandswerts des zweiten Spannungsteilerwiderstands 46 und des Einschaltwiderstands des Ausgangsschalters 47 ist. Dabei ist 0 Volt als Wert des Bezugspotenzials VSS angenommen.

Mit Vorteil nimmt das Anschlusssignal SWI den Wert des Bezugspotenzials VSS an, sobald das Taktanschlusssignal CLKA den logischen Wert 0 aufweist. Bei einem logischen Wert 0 des Taktanschlusssignals CLKA ist der Wert des Anschlusssignals SWI nicht vom Wert des Dateneingangssignals DINA beeinflusst. Weist hingegen das Taktanschlusssignal CLKA den logischen Wert 1 auf, so nimmt das Anschlusssignal SWI einen höheren Spannungswert im Falle eines logischen Wertes 1 des Dateneingangssignals DINA verglichen mit einem Wert im Falle des Vorliegens des logischen Wert 0 im Dateneingangssignal DINA an. Entsprechend dem Wert des Dateneingangssignals DINA kann somit das Anschlusssignal SWI alternativ den Wert der Versorgungsspannung VDD oder des Zwischenpegels SZ, also beispielsweise der Hälfte der Versorgungsspannung VDD, annehmen. Hierbei ist der Widerstandswert R1A des ersten Spannungsteilerwiderstands 43 näherungsweise gleich dem Widerstandswert R1B, welcher vom zweiten Spannungsteilerwiderstand 46 und vom Ausgangsschalter 47 im eingeschalteten Zustand gebildet wird.

Aus dem Anschlusssignal SWI kann darüber hinaus das Datenausgangssignal DOUTA gewonnen werden. Dazu wird der Wert des Anschlusssignals SWI mit dem vom Referenzspannungsteiler 50 bereitgestellten Referenzwert verglichen. Weist das Anschlusssignal SWI einen Wert höher als der Referenzwert des Referenzspannungsteilers 50 auf, so nimmt das Datenausgangssignal DOUTA den logischen Wert 1 an. Hat hingegen das Anschlusssignal SWI einen Wert niedriger als den Referenzwert, so weist das Datenausgangssignal DOUTA den logischen Wert 0 auf. Der Referenzwert ist zwischen dem Zwischenpegel SZ und der Versorgungsspannung VDD. Zum Auslesen von Daten aus dem Anschlusssignal SWI wird der Ausgangsschalter 47 derart eingestellt, dass er den Spannungswert am Ausgangsanschluss 40 nicht beeinflusst. Somit kann von der Ausgangsschaltungsanordnung 12 sowohl Informationen mittels des Dateneingangssignals DINA an dem Ausgangsanschluss 40 bereitgestellt werden, als auch das Taktanschlusssignal CLKA dem Ausgangsanschluss 40 zugeleitet werden wie auch Daten in Form des Datenausgangssignals DOUTA am Ausgangsanschluss 40 empfangen werden. Das System 10 realisiert eine Schnittstelle für einen Datenaustausch zwischen dem Schaltungsblock 32 und dem Schnittstellensteuerungsblock 54, welcher eine externe Schaltung darstellt. Das System bildet eine I2C-Schnittstelle nach. Alternativ kann das System auch ein Serial Peripheral Interface, abgekürzt SPI Schnittstelle, nachbilden. Die zwei oder drei Leitungen für eine derartige Schnittstelle werden hier zu einer Leitung an dem Anschluss 13 zusammengefasst. Das System 10 verwendet dazu das Anschlusssignal SWI mit drei Signalpegeln und kodiert zusätzlich die Betriebsart über die Geschwindigkeit der Änderung des Anschlusssignals SWI, genauer gesagt der abfallenden Flanke des Anschlusssignals SWI. Der Anschluss 13 ist multifunktionell genutzt. Das System 10 kommt somit mit einer kleinen Anzahl von Anschlüssen und Anschlussflächen aus.

In einer alternativen, nicht gezeigten Ausführungsform ist der Ausgangsanschluss 40 mit dem Anschluss 13 lösbar verbunden. Die Verbindung ist nicht permanent. Der Ausgangsanschluss 40 kann mit dem Anschluss 13 über einen Steckkontakt verbunden sein.

In einer alternativen, nicht gezeigten Ausführungsform ist die Ausgangsschaltungsanordnung 12 durch einen Signalgenerator ersetzt, der das Anschlusssignal SWI mit verschiedenen Pegeln bildet. Der Signalgenerator kann auch als Produktionstester bezeichnet werden. Mit Hilfe eines derartigen Produktionstesters kann effektiv die Eingangsschaltungsanordnung 11 charakterisiert werden.

In einer alternativen, nicht gezeigten Ausführungsform umfasst das resistive Element 29 eine Diode oder/und einen Transistor, welcher als Widerstand verschaltet ist.

In einer alternativen, nicht gezeigten Ausführungsform ist der Schalter 30 an den Anschluss 13 und das resistive Element 29 an den Bezugspotenzialanschluss 28 angeschlossen.

In einer alternativen, nicht gezeigten Ausführungsform ist das resistive Element 29 in den Schalter 30 integriert. Der Schalter 30 ist derart angesteuert, dass er wahlweise in einen offenen Betriebszustand oder in einen Betriebszustand, in dem die gesteuerte Strecke des Schalters 30 den vorgegebenen Widerstandswert entsprechend den oben angegebenen Bereichen aufweist, versetzt wird.

In einer nicht gezeigten, alternativen Ausführungsform ist der zweite Spannungsteilerwiderstand 46 an den Bezugspotenzialanschluss 28 und der Ausgangsschalter 47 an den Ausgangsanschluss 41 angeschlossen.

In einer alternativen Ausführungsform umfasst die Erkennungsschaltung 14 einen Ausschalter 35, der zwischen dem Ausgang des ersten Vergleichers 17 und dem Taktausgang 19 geschaltet ist. Die Erkennungslogik 22 steuert den Ausschalter 35. Im Fall der ersten Betriebsart A ist der Ausschalter 35 in Durchlass geschaltet. Im Fall der zweiten Betriebsart B verbindet der Ausschalter 35 den Taktausgang 19 mit einem Anschluss mit einer konstanten Spannung wie beispielsweise dem Bezugspotenzialanschluss 28 oder dem Versorgungsspannungsanschluss 34. Somit sind in der zweiten Betriebsart B mit Vorteil am Datenanschluss 20 sowie am Taktausgang 19 ausschließlich konstante Spannungen beziehungsweise das Bezugspotenzial VSS abgreifbar und können an diesen beiden Anschlüssen 19, 20 keine zeitabhängigen Signale abgegriffen werden. Die Takt- und Datenschnittstelle ist somit in der zweiten Betriebsart B blockiert.

In einer alternativen, nicht gezeigten Ausführungsform ist dem Anschluss 13 ein Filter nachgeschaltet, das zur Filterung des Anschlusssignals SWI dient.

Figur 1B zeigt eine weitere beispielhafte Ausführungsform des Systems nach dem vorgeschlagenen Prinzip, welche eine Weiterbildung des in Figur 1A gezeigten Systems ist. Der Anschluss 13 ist zusätzlich zum Ausgangsanschluss 40 mit einem Analoganschluss 60 verbunden. Die Erkennungsschaltung 14 weist einen weiteren Datenanschluss 63 auf. Der weitere Datenanschluss 63 ist mit dem Schaltungsblock 32 verbunden. Der Schaltungsblock 32 ist als Speicher ausgebildet.

Der erste und der zweite Vergleicher 17, 18 sind als ein erster beziehungsweise ein zweiter Inverter 61, 62 realisiert. Die Umschaltschaltschwelle eines Inverters hängt von der Schwellspannung des p-Kanal Transistors, der Schwellspannung des n-Kanal Transistors, dem Weiten-zu-Längenverhältnis des p-Kanal Transistors sowie dem Weiten-zu-Längenverhältnis des n-Kanal Transistors ab. Der erste und der zweite Inverter 61, 62 sind derart realisiert, dass die erste Schaltschwelle SREF1 des ersten Inverters 61 niedriger als die zweite Schaltschwelle SREF2 des zweiten Inverters 62 ist.

Der Signalkonverter 27 weist einen dritten Inverter 64 auf, der ausgangsseitig mit dem Steueranschluss des Schalters 30 verbunden ist. Der Schalter 30 ist als Feldeffekttransistor implementiert. Bevorzugt ist der Schalter 30 als n-Kanal Metall-Oxid-Halbleiter Feldeffekttransistor realisiert. Der Datenausgang 31 ist an einen Eingang des dritten Inverters 64 angeschlossen.

Die Eingangsschaltungsanordnung 11 umfasst ein Messobjekt 65. Das Messobjekt 65 ist mit dem Anschluss 13 gekoppelt. Das Messobjekt 65 ist über das resistive Element 29 mit dem Anschluss 13 verbunden. Weiter ist das Messobjekt 65 über einen Aktivierschalter 66 mit dem Bezugspotenzialanschluss 28 gekoppelt. Der Aktivierschalter 66 ist als n-Kanal Metall-Oxid-Halbleiter Feldeffekttransistor realisiert. Der Schaltungsblock 32 umfasst das Messobjekt 65 und den Aktivierschalter 66. Die Eingangsschaltungsanordnung 11 weist einen Aktivieranschluss 67 auf, der mit einem Steueranschluss des Aktivierschalters 66 verbunden ist. Der Aktivierschalter 66 ist wie der Schalter 30 realisiert. Der Aktivierschalter 66 und der Schalter 30 weisen denselben Einschaltwiderstand auf.

Der Ausgangsschalter 47 ist als Feldeffekttransistor realisiert. Bevorzugt ist der Ausgangsschalter 47 als n-Kanal Metall-Oxid-Halbleiter Feldeffekttransistor realisiert. Die Ausgangsschaltungsanordnung 12 weist einen Ausgangsinverter 48 auf, der den Dateneingang 45 mit dem Steuereingang des Ausgangsschalters 47 koppelt. Der Ausgangsinverter 48 kann in einer alternativen Ausführungsform weggelassen werden und durch eine Invertierung des Dateneingangssignals DINA im Schnittstellensteuerungsblock 54 ersetzt werden.

Der erste und der zweite Inverter 61, 62 bilden das erste und das zweite Vergleichersignal SK1, SK2. Durch die Realisierung der beiden Vergleicher 17, 18 als Inverter 61, 62 ist der Aufwand für die Implementierung der Vergleicher 17, 18 sehr niedrig gehalten. Darüber hinaus stellen der erste und der zweite Inverter 61, 62 das erste und das zweite Vergleichersignal SK1, SK2 mit nur einer äußerst geringen zeitlichen Verzögerung verglichen mit dem Anschlusssignal SWI bereit.

Der Signalzwischenspeicher 23 umfasst den Puffer 36, der den Anschluss 13 mit dem Pufferausgang 24 koppelt. Der Signalzwischenspeicher 23 ist unidirektional ausgebildet. Der weitere Schaltungsblock 33 umfasst die Ausgangsaktivschaltung 39, die an einem Steuereingang mit dem Pufferausgang 24 verbunden ist. Die Ausgangsaktivschaltung 39 koppelt den Versorgungsspannungsanschluss 34 mit einem geschaltenen Versorgungsanschluss 38. Die Ausgangsaktivschaltung 39 umfasst einen Transistor. Der Transistor wird mit dem Eingangssignal SE angesteuert und versorgt einen nicht gezeigten Schaltungsteil der Eingangsschaltungsanordnung 11 mit der Versorgungsspannung VDD.

Am Datenausgang 31 liegt ein Ausgangssignal DOUT an. Der dritte Inverter 64 generiert das invertierte Ausgangssignal DOUTN durch Invertierung des Ausgangsignals DOUT. Das invertierte Ausgangssignal DOUTN wird dem Schalter 30 zugeleitet.

Am Analoganschluss 60 liegt eine Analogspannung VAN an. Am Aktivieranschluss 67 ist ein Aktiviersignal SAN abgreifbar, das dem Aktivierschalter 66 zugeleitet wird. Mit dem Aktiviersignal SAN und dem Aktivierschalter 66 wird erreicht, dass das Messobjekt 65 in einen Strompfad zwischen dem Anschluss 13 und dem Bezugspotenzialanschluss 28 geschaltet ist. Das Messobjekt 65 kann beispielsweise eine einmal programmierbare Speicherzelle, englisch one time programmable cell, abgekürzt OTP-cell, sein. Das Messobjekt 65 ist beispielsweise eine Sicherung, englisch Fuse, die einen Widerstandswert aufweist. Mit Hilfe des Aktivierschalters 66 wird ein Stromfluss durch das Messobjekt 65 ermöglicht, der zu einem Spannungsabfall des Anschlusssignals SWI führt. Das Messobjekt 65 weist einen Widerstandswert RMES auf. Aus dem Widerstandswert des ersten resistiven Elements 29, dem Widerstandswert des ersten Spannungsteilerwiderstands 43, dem Spannungswert der Analogspannung VAN und dem Spannungswert der Versorgungsspannung VDD kann der Widerstandswert RMES des Messobjekts 65 berechnet werden. Die analoge Widerstandsmessung des Widerstandswerts RMES ermöglicht eine Qualitätssicherung des Messobjekts 65.

Somit kann zusätzlich über den Anschluss 13 analog vorliegende Informationen der Eingangsschaltungsanordnung 11 bereitgestellt werden. Somit wird eine analoge Messung an einem digitalen Anschluss 13 beziehungsweise Anschlussfläche 15 durchgeführt. Eine zusätzliche Anschlussfläche wird nicht zur analogen Messung benötigt. Der Speicher im Schaltungsblock 32 kann somit effizient angesteuert werden. Sowohl das Einlesen von Daten, das Programmieren der programmierbaren Zellen, das Auslesen von Daten und das Messen des Widerstandswerts einer Zelle können über den Anschluss 13 erfolgen. Die standardisierte Aktivierung der Schnittstelle ermöglicht, ein wieder verwendbares Testprogramm für den Speicher zu entwickeln.

In einer alternativen, nicht gezeigten Ausführungsform umfasst der erste Vergleicher 17 einen weiteren Inverter, der zwischen dem ersten Inverter 61 und der Erkennungsschaltung 14 angeordnet ist. Entsprechend umfasst der zweite Vergleicher 18 einen zusätzlichen Inverter, der zwischen dem zweiten Inverter 62 und der Erkennungsschaltung 14 angeordnet ist.

In einer alternativen, nicht gezeigten Ausführungsform sind zwischen dem Messobjekt 65 und dem Anschluss 13 weitere Schalter angeordnet. Ferner sind zwischen dem Messobjekt 65 und dem Bezugspotentialanschluss 28 weitere Schalter angeordnet. Alternativ ist das Messobjekt 65 ohne Zwischenschaltung des resistiven Elements 29 mit dem Anschluss 13 verbunden.

In einer alternativen, nicht gezeigten Ausführungsform koppelt der Aktivierschalter 66 das Messobjekt 65 mit dem Versorgungsspannungsanschluss 34.

Figur 2A zeigt beispielhafte Ausführungsformen von Signalverläufen eines Systems nach dem vorgeschlagenen Prinzip in Abhängigkeit der Zeit t. In Figur 2A ist das Taktanschlusssignal CLKA, das Dateneingangssignal DINA, das Datenausgangssignal DOUTA, das Anschlusssignal SWI, das Taktsignals CLK, das Datensignal DIN und das invertierte Ausgangssignal DOUTN dargestellt. In einem ersten Zeitraum zwischen einem ersten Zeitpunkt t1 und einem zweiten Zeitpunkt t2 ist das Taktanschlusssignal CLKA und das Dateneingangssignal DINA jeweils auf dem logischen Wert 1 und weisen den Wert der Versorgungsspannung VDD auf. Das Anschlusssignal SWI weist den Spannungswert des Taktanschlusssignals CLKA auf. Zum Zeitpunkt t1', welcher dem erstem Zeitpunkt t1 folgt, wird das Dateneingangssignal DINA auf den logischen Wert 0 gesetzt und nimmt somit den Spannungswert 0 Volt an. Mittels des Dateneingangssignals DINA wird folglich der Ausgangsschalter 47 leitend geschaltet, so dass das Anschlusssignal SWI den Zwischenpegel SZ, das heißt einen Wert zwischen der Versorgungsspannung und 0 Volt annimmt. Sind der Widerstandswert des ersten Spannungsteilerwiderstands 43 und der Widerstandswert der Serienschaltung aus dem Ausgangsschalter 47 und dem zweitem Spannungsteilerwiderstand 46 gleich, so sinkt zum Zeitpunkt t1' das Anschlusssignal SWI auf den Wert der Hälfte der Versorgungsspannung VDD.

Zu einem Zeitpunkt t1", welcher dem Zeitpunkt t1' folgt, wechselt das Taktanschlusssignal CLKA vom logischen Wert 1 auf den logischen Wert 0, so dass das Anschlusssignal SWI auf einen Referenzwert, das heißt dem Spannungswert des Bezugspotentials VSS, also 0 Volt absinkt. Somit ist das Absinken des Anschlusssignals SWI vom Wert der Versorgungsspannung VDD auf 0 Volt über eine Stufe durchgeführt. Das Absinken des Anschlusssignals SWK erfolgt somit mit einer geringen Steilheit. Somit erkennt die Eingangsschaltungsanordnung 11 die erste Betriebsart A. Die Steilheit der Änderung des Anschlusssignals SWI kann beispielsweise als das Verhältnis von einem Spannungsunterschied $\Delta U$ des Anschlusssignals SWI zu der Zeitdauer $\Delta t$, welche das Anschlusssignal SWI für die Änderung um diesen Spannungsunterschied $\Delta U$ benötigt, definiert sein. Die Steilheit kann beispielsweise beim Übergang des Anschlusssignals SWI von der Versorgungsspannung VDD zum Bezugspotential VSS bestimmt werden; der Spannungsunterschied $\Delta U$ kann dabei der Wert der Versorgungsspannung VDD abzüglich des Werts des Bezugspotentials VSS sein. Alternativ kann die Steilheit beispielsweise zwischen 90% (VDD - VSS) und 10% (VDD - VSS) bestimmt werden.

Die Steilheit wird durch den Spannungsunterschied zwischen dem zweiten Schwellwert SREF2 und dem ersten Schwellwert SREF1, die Pulsdauer des durch den Zeitgeber 21, der auch als Taktgeber bezeichnet werden kann, bereitgestellten Pulssignals ST sowie durch die Anzahl der Pulse zwischen den Flanken des ersten und des zweiten Vergleichersignals SK1, SK2 bestimmt. Die Pulsdauer kann beispielsweise 10 $\mu$s sein. Ist die von der Erkennungslogik 22 gezählte Anzahl der Pulse größer als ein vorgegebener Wert, so wird die erste Betriebsart A erkannt. Ist die gezählte Anzahl der Pulse kleiner oder gleich dem vorgegebenen Wert, so wird die zweite Betriebsart B erkannt.

In einem zweiten Zeitraum zwischen dem zweiten Zeitpunkt t2 und einem dritten Zeitpunkt t3 weist das Taktanschlusssignal CLKA einen Puls auf. Das Dateneingangssignal DINA hat den logischen Wert 0. Das Anschlusssignal SWI im zweiten Zeitraum hat einen Puls in der Höhe von VDD/2 und führt somit zu einem Puls im Taktsignal CLK und zum logischen Wert 0, der auch als L oder Low bezeichnet werden kann, im Datensignal DIN.

In einem dritten Zeitraum zwischen dem dritten Zeitpunkt t3 und einem vierten Zeitpunkt t4 weist das Taktanschlusssignal CLKA einen Puls auf und nimmt das Dateneingangssignal DINA den logischen Wert 1, der auch als H oder High bezeichnet werden kann, an. Folglich weist das Anschlusssignal SWI einen Puls in der Höhe der Versorgungsspannung VDD auf. Dies führt zu einem Puls im Taktsignal CLK und zu einem logischen Wert 1 des Datensignals DIN.

In einem vierten Zeitraum zwischen dem vierten Zeitpunkt t4 und einem fünften Zeitpunkt t5 ist die analoge Messung des Widerstandswerts RMES des Messobjekts 65 demonstriert. Das Taktanschlusssignal CLKA weist einen Puls auf. Weiter ist das Dateneingangssignal DINA auf den logischen Wert 1 gesetzt. Mit Hilfe des in Figur 1B gezeigten Aktiviersignals SAN wird das Messobjekt 65 zwischen den Anschluss 13 und dem Bezugspotenzialanschluss 28 geschaltet, so dass auch bei einem logischen Wert 1 des Dateneingangssignals DINA am Analoganschluss 60 nicht der Wert der Versorgungsspannung VDD, sondern einen Spannungswert zwischen dem Wert der Versorgungsspannung VDD und der Hälfte der Versorgungsspannung erreicht wird. Aus der erreichten Analogspannung VAN am Analoganschluss 60, die dem Spannungswert des Anschlusssignals SWI entspricht, kann der Widerstandswert RMES des Messobjekts 65 berechnet werden. Der Puls im Datensignal DIN wird unterdrückt.

Das Datenausgangsignal DOUTA nimmt entweder den logischen Wert 1 oder den logischen Wert 0 an, je nachdem ob der analoge Pegel des Anschlusssignals SWI den Referenzpegel des Komparators 49 überschreitet oder nicht.

In einem fünften Zeitraum zwischen dem fünften Zeitpunkt t5 und einem sechsten Zeitpunkt t6 weist das Taktsignal CLKA einen Puls auf und DINA den logischen Wert 1. Dadurch dass das invertierte Ausgangssignal DOUTN einen positiven Puls erzeugt, wird am Anschlusssignal SWI nur ein Puls in der Höhe der Hälfte der Versorgungsspannung VDD gemessen, der Ausgang des Komparators 49 generiert damit den logischen Wert 0 des Datenausgangssignals DOUTA.

In einem sechsten Zeitraum zwischen dem sechsten Zeitpunkt t6 und einem siebten Zeitpunkt t7 zeigt das Taktanschlusssignal CLKA einen Puls und weist weiter das invertierte Ausgangssignal DOUTN den logischen Wert 0 und das Dateneingangssignal DINA den logischen Wert 1 auf. Das bereitgestellte Anschlusssignal SWI zeigt einen Puls in Höhe der Versorgungsspannung VDD. Dies wird mit Hilfe des Komparators 49 in ein Datenausgangssignal DOUTA mit dem logischen Wert 1 umgewandelt. Für das digitale Lesen wird somit der zweite Spannungsteilerwiderstand 46 über den Ausgangsschalter 47 ausgeschaltet und das resistive Element 29, das einen etwa gleich großen Widerstandswert wie der zweite Spannungsteilerwiderstand 46 aufweist, über den Schalter 30 in Abhängigkeit vom Ausgangssignal DOUT, während der Pegel des Taktanschlusssignals CLKA VDD erreicht, dazugeschaltet oder auch nicht. Dadurch wird der Pegel am Anschluss 13 auf VDD/2 gezogen beziehungsweise bleibt auf VDD. Der Komparator 49 wandelt den Pegel am Anschluss 13 in ein digitales HIGH oder LOW um und generiert das Datenausgangssignal DOUTA.

In einem siebten Zeitraum zwischen dem siebten Zeitpunkt t7 und einem achten Zeitpunkt t8 erfolgt ein langsames Ansteigen des Anschlusssignals SWI. Das langsame Ansteigen des Anschlusssignals SWI wird durch den Übergang des Taktanschlusssignals CLKA vom logischen Wert 0 auf den logischen Wert 1 zu einem Zeitpunkt t7' und dem anschließenden Übergang des Dateneingangssignals DINA vom logischen Wert 0 auf den logischen Wert 1 zu einem Zeitpunkt t7" erzielt. Somit wird eine Stoppbedingung von der Eingangsschaltungsanordnung 11 erkannt, so dass die erste Betriebsart A ausgeschaltet werden kann. Die Eingangsschaltungsanordnung 11 wechselt somit beim Erkennen der Stoppbedingung von der ersten Betriebsart A in die zweite Betriebsart B. Figur 2A zeigt I2C kompatible Signalformen.

Figur 2B zeigt weitere beispielhafte Signalformen des Systems 10 nach dem vorgeschlagenen Prinzip. In Figur 2B ist das Anschlusssignal SWI, das Eingangssignal SE und das weitere Datensignal SEN in Abhängigkeit von der Zeit t gezeigt. In Figur 2B ist eine Übertragungssequenz der Schnittstelle gezeigt. Die Übertragungssequenz kann als Aktivierungssequenz realisiert sein. In einem zehnten Zeitraum zwischen einem zehnten Zeitpunkt t10 und einem elften Zeitpunkt t11 zeigt das Anschlusssignal SWI einen positiven Puls, der zu einem Puls des Eingangssignals SE führt. Da eine zeitliche Änderung bei der abfallenden Flanke des Anschlusssignals SWI sehr schnell ist, ist die Eingangsschaltungsanordnung 11 in der zweiten Betriebsart B. Im zehnten Zeitraum erfolgt eine weitere positive Flanke des Anschlusssignals SWI. In einem elften Zeitraum zwischen dem elften Zeitpunkt t11 und einem zwölften Zeitpunkt t12 folgt die negative Flanke des Anschlusssignals SWI mit einer Stufe. Die fallende Flanke im Anschlusssignal SWI hat somit eine geringe Geschwindigkeit.

Dadurch erkennt die Erkennungsschaltung 14 die erste Betriebsart A. Die Erkennungsschaltung 14 und der Signalzwischenspeicher 23 sind derart ausgelegt, dass auch bei Erkennung der ersten Betriebsart A das Eingangssignal SE weiterhin den logischen Wert 1 aufweist. Das Eingangssignal SE ist im Signalzwischenspeicher 23 gespeichert und wird für die Dauer der ersten Betriebsart A beibehalten.

In Figur 2B werden beispielhaft Signalverläufe des in Figur 1B gezeigten Systems dargestellt. In einem zwölften Zeitraum zwischen dem zwölften Zeitpunkt t12 und einem dreizehnten Zeitpunkt t13 befindet sich die Eingangsschaltungsanordnung 11 in der ersten Betriebsart A. Nach dem Ausführen der Startbedingung im elften Zeitraum wird die Übertragungssequenz initialisiert. In der Erkennungsschaltung 14 wird der Zeitgeber 21 gestartet. Die Erkennungslogik 22 zählt die Pulse des Pulssignals ST, so dass während der gesamten vorgegebenen Maximalzeitdauer TOUT die normale Funktion des Anschluss 13 ausgeblendet ist und sich die Eingangsschaltungsanordnung in der ersten Betriebsart A befindet. In diesem Zeitraum wird die Übertragungssequenz geschrieben. Als normale Funktion wird die zweite Betriebsart B verstanden. Die Übertragungssequenz folgt den Vorgaben für eine Übertragungssequenz eines I2C-Interfaces. Die Übertragungssequenz dient der Übertragung mindestens eines Bytes. In Figur 2B werden drei Bytes in der Übertragungssequenz übertragen. Die Übertragungssequenz ist in mehrere Einzelsequenzen C aufgeteilt. Die Übertragungssequenz hat somit als Aufbau, dass zuerst eine 8 Bit Slave-Adresse mit einem Erkennungspuls, englisch acknowledge pulse, anschließend eine 8 Bit Register-Adresse mit Erkennungspuls und wiederum anschließend 8 Bit Daten mit Erkennungspuls mit Hilfe des Anschlusssignals SWI der Eingangsschaltungsanordnung 11 übertragen werden. Eine erste Einzelsequenz C dient somit zur Übertragung einer Bauelement-Adresse, englisch device address oder slave address. In einer zweiten Einzelsequenz C wird eine Register-Adresse übertragen. In einer dritten Einzelsequenz C werden Registerdaten übermittelt. Die Registerdaten können beispielsweise zur Programmierung von einmal-programmierbaren Speicherzellen dienen.

Bei diesem Beispiel besteht somit der Code der Übertragungssequenz aus 27 Bit. Der Code aus 27 Bit ist in der von dem Zeitgeber 21 vorgegebenen Maximalzeitdauer TOUT zu schreiben. Die Vorgabe der Codelänge und die Vorgabe der Maximalzeitdauer TOUT bietet einen geeigneten Schutz vor allem vor zufälligem Versetzen der Eingangsschaltungsanordnung 11 in die erste Betriebsart A. Enthält das Anschlusssignal SWI einen fehlerhaften Code, das heißt einen Code, der von vorgegebenen Werten des Codes abweicht, oder wird der Code zu langsam, das heißt nicht in der vorgeschriebenen Maximalzeitdauer TOUT geschrieben, so wird die Übertragungssequenz abgebrochen und die Eingangsschaltungsanordnung 11 wechselt von der ersten Betriebsart A in die zweite Betriebsart B.

Das Eingangssignal SE ist während der ersten Betriebsart A konstant und folgt nicht dem Anschlusssignal SWI. Die zweite Betriebsart B ist während der Aktivierung nicht aktiv. In der zweiten Betriebsart B würde ansonsten das Eingangssignal SE dem Anschlusssignal SWI folgen, was bei der Ausführung des Eingangssignals SE als Enable-Signal zu einem dauernden Aus- und Einschalten der Eingangsschaltungsanordnung 11 führen könnte. Die Maximalzeitdauer TOUT ist so vorgegeben, dass ihr Wert hoch genug ist, so dass der Code mit der Übertragungssequenz innerhalb der Maximalzeitdauer TOUT abgesetzt werden kann. Weiter ist die Maximalzeitdauer TOUT so kurz gewählt, dass nach einer irrtümlich abgesetzten Startbedingung die zweite Betriebsart B, welche die normale Funktion der Eingangsschaltungsanordnung 11 darstellt, nur unmerklich verzögert wird.

In einer Ausführung kann statt der Maximalzeitdauer TOUT eine Auszeit definiert werden, innerhalb dieser ein Puls erfolgen muss. Nach jedem Puls wird diese Auszeit neu gestartet. Dies entspricht somit einer minimalen Frequenz für die Datenübertragung und lässt auch längere Pulssequenzen zu. Wird die Auszeit überschritten, so wird von der ersten Betriebsart A in die zweite Betriebsart B umgeschaltet.

In einer Ausführungsform kann die Aktivierung zusätzlich mit einem Verriegelungsbit versehen werden, um die Schnittstelle vollständig deaktivieren zu können; ein Versetzen in die erste Betriebsart A ist somit nicht mehr möglich.

Figur 3 zeigt eine beispielhafte Ausführungsform des Systems nach dem vorgeschlagenen Prinzip, das eine Weiterbildung des in den Figuren 1A und 1B gezeigten Systems ist. Ein erster Halbleiterkörper 80 umfasst die Eingangsschaltungsanordnung 11 mit der Anschlussfläche 15, englisch Pad, und dem Anschluss 13. Darüber hinaus umfasst ein zweiter Halbleiterkörper 81 die Ausgangsschaltungsanordnung 12 mit dem Ausgangsanschluss 40 und der weiteren Anschlussfläche 41, englisch Pad. Ein Verbindungsdraht 82 verbindet die Anschlussfläche 15 mit der weiteren Anschlussfläche 41. Der erste und der zweite Halbleiterkörper 80, 81 sind auf einem Träger 83 aufgebracht.

In einer alternativen, nicht gezeigten Ausführungsform sind der erste und der zweite Halbleiterkörper 80, 81 in Flip-Chip-Technik auf dem Träger 83 aufgebracht. Dazu weist der Träger 83 eine Leiterbahn auf. Der erste Halbleiterkörper 80 ist mit derjenigen Oberfläche auf dem Träger 83 aufgebracht, welcher die Anschlussfläche 15 aufweist. Entsprechend ist der zweite Halbleiterkörper 81 mit derjenigen Oberfläche auf dem Träger 83 angeordnet, welche die weitere Anschlussfläche 40 umfasst. Die Verbindung der Anschlussfläche 15 mit der weiteren Anschlussfläche 40 wird über eine Lötkugel oder einen Löthöcker, englisch Bump, zwischen der Anschlussfläche 15 und der Leiterbahn auf dem Träger 83 und der Leiterbahn sowie einer Lötkugel oder einen Löthöcker zwischen der Leiterbahn auf dem Träger 83 und der weiteren Anschlussfläche 40 realisiert.

Das System 10 realisiert eine Eindraht-Schnittstelle: Ein zusätzlicher Pegel, der Zwischenpegel SZ, wird bei der Hälfte der Versorgungsspannung VDD/2 definiert, der zusätzlich zu den digitalen Pegeln Versorgungsspannung VDD für den logischen Wert 1 beziehungsweise H und Bezugspotential VSS für den logischen Wert 0 beziehungsweise L verwendet werden kann. Intern werden diese Pegel durch den ersten und den zweiten Komparator 17, 18 bestimmt, deren Schaltschwellen SREF1 beziehungsweise SREF2 in geeigneter Weise zwischen VDD und VDD/2 sowie zwischen VDD/2 und VSS liegen. Weiter ist das Systems 10 kompatibel zum I2C Protokoll: Durch geeignete interne Separation der Multilevel-Signale des Anschlusssignals SWI am Anschluss 13 werden die I2C-Signale SCL und SDA, oben als Taktsignal CLK und Datensignal DIN bezeichnet, nachgebildet und das Interface auf einen internen I2C-Bus angedockt.

Das System 10 weist eine standardisierte Aktivierung des Schnittstellen-Anschlusses 13 auf: Die I2C Start-Sequenz VDD-VDD/2 - VSS ermöglicht es, die Übertragungssequenz zu starten, damit startet ein internes Timeout mit der Maximalzeitdauer TOUT. Während dieser Zeit ist die normale Funktion des Anschlusses 13 für kurze Zeit ausgeblendet. Falls eine Zeitüberschreitung der Maximalzeitdauer TOUT stattfindet oder die Befehlsfolge falsch ist, ist die normale Funktion, das heißt die zweite Betriebsart B, wieder vollständig aktiv. Wird aber ein gültiger Aktivierungscode innerhalb des Timeouts mit der Maximalzeitdauer TOUT abgesetzt, so bleibt der Anschluss 13 bis auf weiteres in der ersten Betriebsart A und damit als Interface aktiv. Eine direkte Messung am Analoganschluss 60 direkt an der Anschlussfläche 15 kann zur Berechnung des analogen Widerstandes RMES des Messobjekts 65 verwendet werden.

Bezugszeichenliste

| | |
|---|---|
| 10 | System |
| 11 | Eingangsschaltungsanordnung |
| 12 | Ausgangsschaltungsanordnung |
| 13 | Anschluss |
| 14 | Erkennungsschaltung |

| | |
|---|---|
| 15 | Anschlussfläche |
| 16 | Auswerteschaltung |
| 17 | erster Vergleicher |
| 18 | zweiter Vergleicher |
| 19 | Taktausgang |
| 20 | Datenanschluss |
| 21 | Zeitgeber |
| 22 | Erkennungslogik |
| 23 | Signalzwischenspeicher |
| 24 | Pufferausgang |
| 25 | Betriebsartausgang |
| 26 | Ausgangsanschluss |
| 27 | Signalkonverter |
| 28 | Bezugspotenzialanschluss |
| 29 | resistives Element |
| 30 | Schalter |
| 31 | Datenausgang |
| 32 | Schaltungsblock |
| 33 | weiterer Schaltungsblock |
| 34 | Versorgungsspannungsanschluss |
| 35 | Ausschalter |
| 36 | Puffer |
| 37 | weiterer Puffer |
| 38 | geschaltener Versorgungsanschluss |
| 39 | Ausgangsaktivschaltung |
| 40 | Ausgangsanschluss |
| 41 | weitere Anschlussfläche |
| 42 | Taktanschluss |
| 43 | erster Spannungsteilerwiderstand |
| 44 | Spannungsteiler |
| 45 | Dateneingang |
| 46 | zweiter Spannungsteilerwiderstand |
| 47 | Ausgangsschalter |
| 48 | Ausgangsinverter |
| 49 | Komparator |
| 50 | Referenzspannungsteiler |
| 51 | erster Vergleichswiderstand |
| 52 | zweiter Vergleichswiderstand |
| 53 | Datenausgang |
| 54 | Schnittstellensteuerungsblock |
| 55 | Anordnung zum Erzeugen eines Zwischenpegels |
| 60 | Analoganschluss |
| 61 | erster Inverter |
| 62 | zweiter Inverter |
| 63 | weiterer Datenanschluss |
| 64 | dritter Inverter |
| 65 | Messobjekt |
| 66 | Aktivierschalter |
| 67 | Aktivieranschluss |
| 80 | erster Halbleiterkörper |
| 81 | zweiter Halbleiterkörper |
| 82 | Verbindungsdraht |
| 83 | Träger |
| A | erste Betriebsart |
| B | zweite Betriebsart |
| C | Einzelsequenz |
| CLK | Taktsignal |
| CLKA | Taktanschlusssignal |

| | |
|---|---|
| DIN | Datensignal |
| DINA | Dateneingangssignal |
| DOUT | Ausgangssignal |
| DOUTA | Datenausgangssignal |
| DOUTN | invertiertes Ausgangssignal |
| SAN | Aktiviersignal |
| SB | Betriebsartsignal |
| SE | Eingangssignal |
| SEN | weiteres Datensignal |
| SK1 | erstes Vergleichersignal |
| SK2 | zweites Vergleichersignal |
| SO | Schaltungsausgangssignal |
| SOEN | Ausgangsaktivschaltungssignal |
| SREF1 | erster Schwellwert |
| SREF2 | zweiter Schwellwert |
| ST | Pulssignal |
| SWI | Anschlusssignal |
| SZ | Zwischenpegel |
| TOUT | Maximalzeitdauer |
| t1 | erster Zeitpunkt |
| t2 | zweiter Zeitpunkt |
| t3 | dritter Zeitpunkt |
| t4 | vierter Zeitpunkt |
| t5 | fünfter Zeitpunkt |
| t6 | sechster Zeitpunkt |
| t7 | siebter Zeitpunkt |
| t8 | achter Zeitpunkt |
| t10 | zehnter Zeitpunkt |
| t11 | elfter Zeitpunkt |
| t12 | zwölfter Zeitpunkt |
| t13 | dreizehnter Zeitpunkt |
| VAN | Analogspannung |
| VDD | Versorgungsspannung |
| VSS | Bezugspotenzial |

**Patentansprüche**

**1.** Eingangsschaltungsanordnung,
die zum wahlweisen Betrieb in einer ersten und einer zweiten Betriebsart (A, B) ausgelegt ist sowie

- einen Anschluss (13) zum Zuführen eines Anschlusssignals (SWI) und
- eine Erkennungsschaltung (14), die eingangsseitig mit dem Anschluss (13) gekoppelt ist und ausgelegt ist, die Eingangsschaltungsanordnung (11) in eine Betriebsart aus einer Gruppe umfassend die erste und die zweite Betriebsart (A, B) in Abhängigkeit von einer Steilheit einer Änderung des Anschlusssignals (SWI) zu versetzen,

umfasst,
wobei in der ersten Betriebsart (A) über den Anschluss (13) sowohl Daten- wie auch Taktinformationen der Eingangsschaltungsanordnung (11) zugeführt werden und in der zweiten Betriebsart (B) die Eingangsschaltungsanordnung (11) ausgelegt ist, ein Eingangssignal (SE), das dem Anschlusssignal (SWI) entspricht, bereitzustellen.

**2.** Eingangschaltungsanordnung nach Anspruch 1,
bei der die Erkennungsschaltung (14) ausgelegt ist,

- die Eingangsschaltungsanordnung (11) in die erste Betriebsart (A) zu versetzen, falls die Steilheit der Änderung des Anschlusssignals (SWI) kleiner als ein vorgegebener Wert ist, und
- die Eingangsschaltungsanordnung (11) in die zweite Betriebsart (B) zu versetzen, falls die Steilheit der Änderung des Anschlusssignals (SWI) größer als der vorgegebene Wert ist.

**3.** Eingangschaltungsanordnung nach Anspruch 1 oder 2,
bei der die Erkennungsschaltung (14) ausgelegt ist, in Abhängigkeit von der Steilheit der fallenden Flanke des Anschlusssignals (SWI) die Eingangsschaltungsanordnung (11) in eine Betriebsart aus der Gruppe umfassend die erste und die zweite Betriebsart (A, B) zu versetzen.

**4.** Eingangschaltungsanordnung nach einem der Ansprüche 1 bis 3,
die Erkennungsschaltung (14) umfassend

- einen Zeitgeber (21) zur Abgabe eines Pulssignals (ST) und
- eine Erkennungslogik (22), die mit dem Anschluss (13) und dem Zeitgeber (21) gekoppelt und ausgelegt ist, bei Erkennen der ersten Betriebsart (A) die Pulse des Pulssignals (ST) zu zählen und die erste Betriebsart (A) innerhalb einer vorgegebenen Maximalzeitdauer (TOUT) beizubehalten.

**5.** Eingangschaltungsanordnung nach Anspruch 4,
bei der die Erkennungslogik (22) ausgelegt ist, innerhalb der vorgegebenen Maximalzeitdauer (TOUT) von der ersten Betriebsart (A) in die zweite Betriebsart (B) umzuschalten, falls das Anschlusssignal (SWI) eine Signalfolge aufweist, die von einer Menge von vorgegebenen Signalfolgen abweicht.

**6.** Eingangschaltungsanordnung nach einem der Ansprüche 1 bis 5,
umfassend einen ersten und einen zweiten Vergleicher (17, 18), die jeweils eingangsseitig mit dem Anschluss (13) und ausgangsseitig mit der Erkennungsschaltung (14) verbunden sind und ausgelegt sind, das Anschlusssignal (SWI) oder ein vom Anschlusssignal (SWI) abgeleitetes Signal mit einem ersten beziehungsweise einem zweiten vorgegebenen Schwellwert (SREF1, SREF2) zu vergleichen und in Abhängigkeit von dem Vergleichsergebnis ein erstes beziehungsweise ein zweites Vergleichersignal (SK1, SK2) der Erkennungsschaltung (14) bereitzustellen.

**7.** Eingangschaltungsanordnung nach Anspruch 6,
bei der die Erkennungsschaltung (14) ausgelegt ist, in der ersten Betriebsart (A) in Abhängigkeit von dem ersten Vergleichersignal (SK1) ein Taktsignal (CLK) und in Abhängigkeit von dem zweiten Vergleichersignal (SK2) ein Datensignal (DIN) abzugeben.

**8.** Eingangschaltungsanordnung nach einem der Ansprüche 1 bis 7,
bei der die Erkennungsschaltung (14) einen Betriebsartausgang (25) zum Bereitstellen eines Betriebsartsignals (SB), das einen ersten Wert bei der ersten Betriebsart (A) und einen zweiten Wert bei der zweiten Betriebsart (B) aufweist, umfasst und die Eingangsschaltungsanordnung (11) einen Signalzwischenspeicher (23) umfasst, der an einem ersten Eingang mit dem Anschluss (13) und an einem zweiten Eingang mit dem Betriebsartausgang (25) gekoppelt ist sowie einen Pufferausgang (24) aufweist.

**9.** Eingangschaltungsanordnung nach Anspruch 8,
bei der der Signalzwischenspeicher (23) ausgelegt ist, in der zweiten Betriebsart (B) einen Wert des Anschlusssignals (SWI) oder eines davon abgeleiteten Signals im Signalzwischenspeicher (23) zu speichern und anschließend mindestens in der ersten Betriebsart (A) am Pufferausgang (24) bereitzustellen.

**10.** Eingangschaltungsanordnung nach einem der Ansprüche 1 bis 9,
umfassend einen Signalkonverter (27), der zwischen dem Anschluss (13) und einem Versorgungsspannungs- oder einem Bezugspotentialanschluss (28, 34) angeordnet ist und ausgelegt ist, das Anschlusssignal (SWI) in Abhängigkeit von dem logischen Wert eines Ausgangssignal (DOUT) zu modulieren.

## Claims

**1.** An input circuit arrangement,
which is configured for being selectively operated in a first and a second operating mode (A, B) and comprises

- a terminal (13) for supplying a terminal signal (SWI) and
- a detection circuit (14) which has its input side coupled to the terminal (13) and is configured to set the input circuit arrangement (11) to an operating mode from a group comprising the first and the second operating mode (A, B) depending on a gradient of an alteration of the terminal signal (SWI),

wherein in the first operating mode (A) both data information and clock information are supplied to the input circuit arrangement (11) via the terminal (13) and in the second operating mode (B) the input circuit arrangement (11) is configured to provide an input signal (SE) corresponding to the terminal signal (SWI).

**2.** The input circuit arrangement according to claim 1,
in which the detection circuit (14) is configured to

- set the input circuit arrangement (11) to the first operating mode (A) if the gradient of the alteration of the terminal signal (SWI) is smaller than a predefined value, and
- set the input circuit arrangement (11) to the second operating mode (B) if the gradient of the alteration of the terminal signal (SWI) is larger than the predefined value.

**3.** The input circuit arrangement according to claim 1 or 2,
in which the detection circuit (14) is configured to set the input circuit arrangement (11) to an operating mode from the group comprising the first and the second operating mode (A, B) depending on the gradient of the falling edge of the terminal signal (SWI).

**4.** The input circuit arrangement according to any of claims 1 to 3,
the detection circuit (14) comprising

- a timer (21) for delivering a pulse signal (ST) and
- a detection logic (22) which is coupled to the terminal (13) and the timer (21) and configured to count the pulses of the pulse signal (ST) when detecting the first operating mode (A) and to maintain the first operating mode (A) within a predefined maximum time duration (TOUT).

**5.** The input circuit arrangement according to claim 4,
in which the detection logic (22) is configured to switch over from the first operating mode (A) to the second operating mode (B) within the predefined maximum time duration (TOUT) if the terminal signal (SWI) comprises a signal sequence which deviates from a set of predefined signal sequences.

**6.** The input circuit arrangement according to any of claims 1 to 5,
comprising a first and a second comparator (17, 18), which each have their input side connected to the terminal (13) and their output side connected to the detection circuit (14) and are configured to compare the terminal signal (SWI) or a signal derived from the terminal signal (SWI) with a first and a second predefined threshold value (SREF1, SREF2), respectively, and to provide the detection circuit (14) with a first and a second comparator signal (SK1, SK2), respectively, depending on a result of the comparison.

**7.** The input circuit arrangement according to claim 6,
in which the detection circuit (14), in the first operating mode (A), is configured to supply a clock signal (CLK) depending on the first comparator signal (SK1) and to supply a data signal (DIN) depending on the second comparator signal (SK2).

**8.** The input circuit arrangement according to any of claims 1 to 7,
in which the detection circuit (14) comprises an operating mode output (25) for providing an operating mode signal (SB) which has a first value in the first operating mode (A) and a second value in the second operating mode (B), and the input circuit arrangement (11) comprises a signal intermediate memory (23) which has coupled a first input to the terminal (13) and a second input to the operating mode output (25) and comprises a buffer output (24).

**9.** The input circuit arrangement according to claim 8,
in which the signal intermediate memory (23) is configured to store in the second operating mode (B) a value of the terminal signal (SWI) or of a signal derived therefrom in the signal intermediate memory (23) and subsequently provide it at least in the first operating mode (A) at the buffer output (24).

**10.** The input circuit arrangement according to any of claims 1 to 9,
comprising a signal converter (27) which is arranged between the terminal (13) and a supply voltage terminal or reference potential terminal (28, 34) and configured to modulate the terminal signal (SWI) depending on the logical value of an output signal (DOUT).

## Revendications

**1.** Agencement de circuit d'entrée,
lequel est conçu pour le fonctionnement au choix dans un premier et un deuxième mode de fonctionnement (A, B) et comprend

- une connexion (13) pour l'amenée d'un signal de connexion (SWI) et
- un circuit de détection (14) qui est couplé en entrée à la connexion (13) et conçu pour mettre l'agencement de circuit d'entrée (11) dans un mode de fonctionnement issu d'un groupe comprenant le premier et le deuxième mode de fonctionnement (A, B) en fonction d'un escarpement d'un changement du signal de connexion (SWI),

sachant que, dans le premier mode de fonctionnement (A), à la fois des informations de données et de cadence sont amenées à l'agencement de circuit d'entrée (11) via la connexion (13) et, dans le deuxième mode de fonctionnement (B), l'agencement de circuit d'entrée (11) est conçu pour mettre à disposition un signal d'entrée (SE) qui correspond au signal de connexion (SWI).

**2.** Agencement de circuit d'entrée selon la revendication 1, dans lequel le circuit de détection (14) est conçu pour

- mettre l'agencement de circuit d'entrée (11) dans le premier mode de fonctionnement (A) dans le cas où l'escarpement du changement du signal de connexion (SWI) est inférieur à une valeur spécifiée, et
- mettre l'agencement de circuit d'entrée (11) dans le deuxième mode de fonctionnement (B) dans le cas où l'escarpement du changement du signal de connexion (SWI) est supérieur à la valeur spécifiée.

**3.** Agencement de circuit d'entrée selon la revendication 1 ou 2,
dans lequel le circuit de détection (14) est conçu pour mettre l'agencement de circuit d'entrée (11) dans un mode de fonctionnement issu du groupe comprenant le premier et le deuxième mode de fonctionnement (A, B) en fonction de l'escarpement du flanc descendant du signal de connexion (SWI).

**4.** Agencement de circuit d'entrée selon l'une des revendications 1 à 3,
le circuit de détection (14) comprenant

- une minuterie (21) destinée à délivrer un signal à impulsions (ST) et
- une logique de détection (22) qui est couplée à la connexion (13) et à la minuterie (21) et conçue pour compter les impulsions du signal à impulsions (ST) en cas de détection du premier mode de fonctionnement (A) et maintenir le premier mode de fonctionnement (A) dans les limites d'une durée de temps maximale (TOUT) spécifiée.

**5.** Agencement de circuit d'entrée selon la revendication 4,
dans lequel la logique de détection (22) est conçue pour basculer du premier mode de fonctionnement (A) au deuxième mode de fonctionnement (B) dans les limites de la durée de temps maximale (TOUT) spécifiée dans le cas où le signal de connexion (SWI) présente une séquence de signal qui diverge d'une quantité de séquences de signal spécifiées.

**6.** Agencement de circuit d'entrée selon l'une des revendications 1 à 5,
comprenant un premier et un deuxième comparateur (17, 18) qui sont respectivement reliés à la connexion (13) côté entrée et au circuit de détection (14) côté sortie et conçus pour comparer le signal de connexion (SWI) ou un signal dérivé du signal de connexion (SWI) avec une première ou respectivement une deuxième valeur seuil (SREF1, SREF2) spécifiée et mettre à disposition un premier ou respectivement un deuxième signal de comparaison (SK1, SK2) du circuit de détection (14) en fonction du résultat de comparaison.

**7.** Agencement de circuit d'entrée selon la revendication 6,
dans lequel le circuit de détection (14) est conçu pour délivrer, dans le premier mode de fonctionnement (A), un signal de cadence (CLK) en fonction du premier signal de comparateur (SK1) et un signal de données (DIN) en fonction du deuxième signal de comparateur (SK2).

**8.** Agencement de circuit d'entrée selon l'une des revendications 1 à 7,
dans lequel le circuit de détection (14) comprend une sortie de mode de fonctionnement (25) pour la mise à disposition d'un signal de mode de fonctionnement (SB) qui présente une première valeur dans le cas du premier mode de fonctionnement (A) et une deuxième valeur dans le cas du deuxième mode de fonctionnement (B) et l'agencement de circuit d'entrée (11) comprend une mémoire intermédiaire de signal (23) qui est couplée à la connexion (13) au niveau d'une première entrée et à la sortie de mode de fonctionnement (25) au niveau d'une deuxième entrée et qui présente une sortie tampon (24).

**9.** Agencement de circuit d'entrée selon la revendication 8,
dans lequel la mémoire intermédiaire de signal (23) est conçue pour mémoriser dans la mémoire intermédiaire de signal (23), dans le deuxième mode de fonctionnement (B), et mettre ensuite à disposition au niveau de la sortie tampon (24), au moins dans le premier mode de fonctionnement (A), une valeur du signal de connexion (SWI) ou d'un signal dérivé de celui-ci.

**10.** Agencement de circuit d'entrée selon l'une des revendications 1 à 9,
comprenant un convertisseur de signal (27) qui est disposé entre la connexion (13) et une connexion de tension d'alimentation ou de potentiel de référence (28, 34) et conçu pour moduler le signal de connexion (SWI) en fonction de la valeur logique d'un signal de sortie (DOUT).

FIG 1A

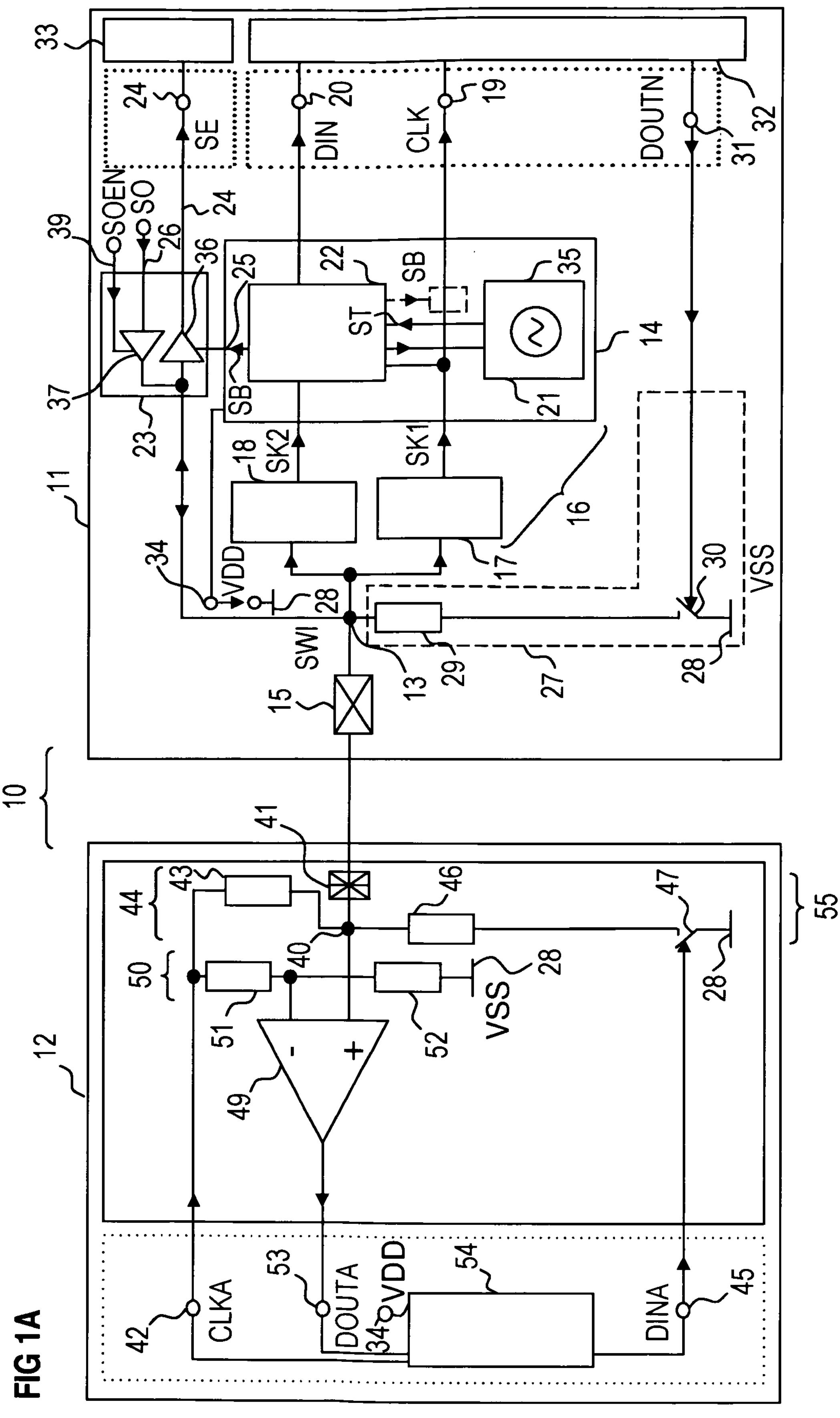
SOEN
SO
SE
DIN
CLK
DOUTN
SB
ST
SK1
SK2
VDD
VSS
SWI
CLKA
DOUTA
DINA
10
11
12
13
14
15
16
17
18
19
20
21
22
23
24
25
26
27
28
29
30
31
32
33
34
35
36
37
39
40
41
42
43
44
45
46
47
49
50
51
52
53
54
55

FIG 1B

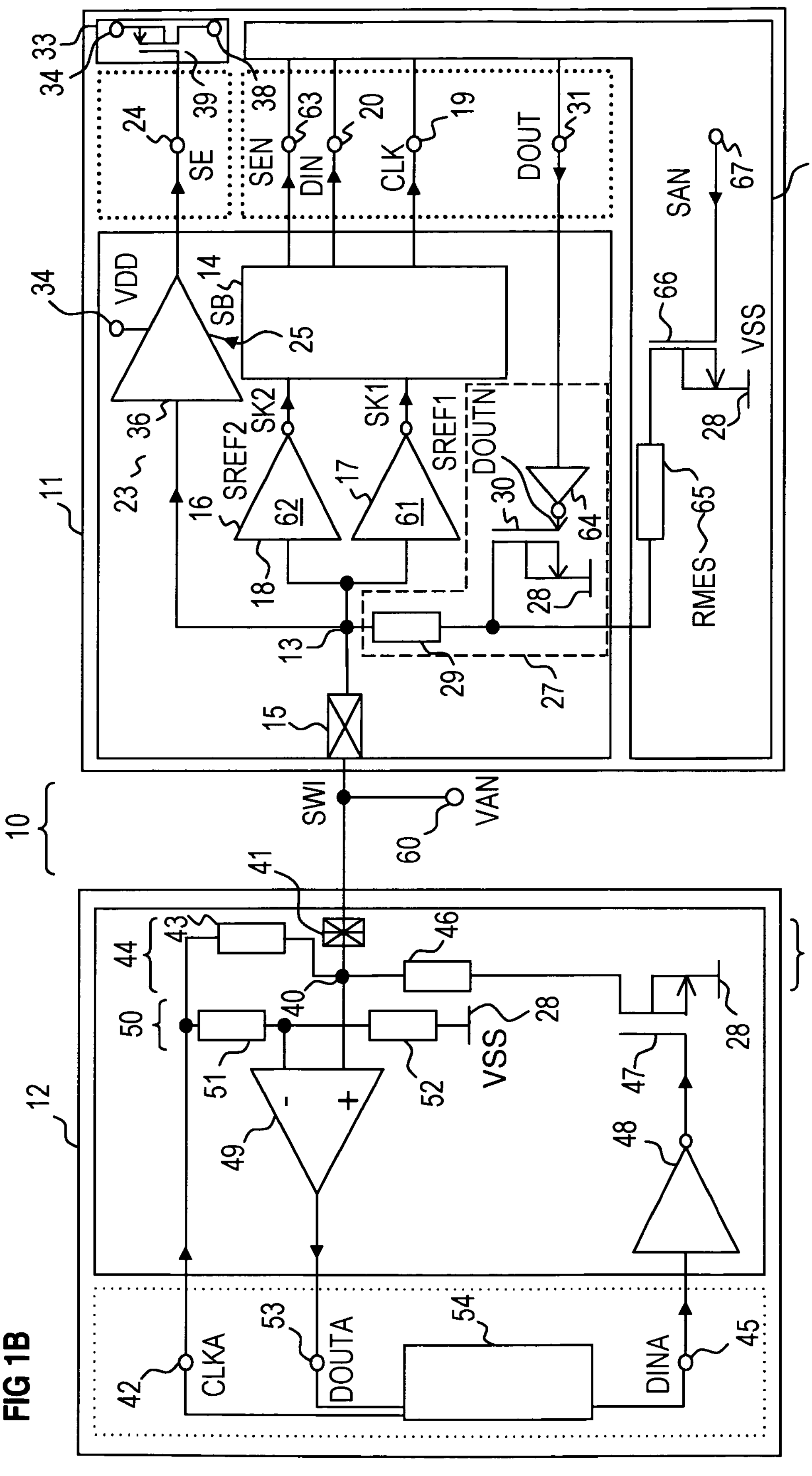
SE
SEN
DIN
CLK
DOUT
SAN
VDD
SB
SK2
SK1
SREF2
SREF1
DOUTN
VSS
RMES
SWI
VAN
VSS
CLKA
DOUTA
DINA

FIG 2A

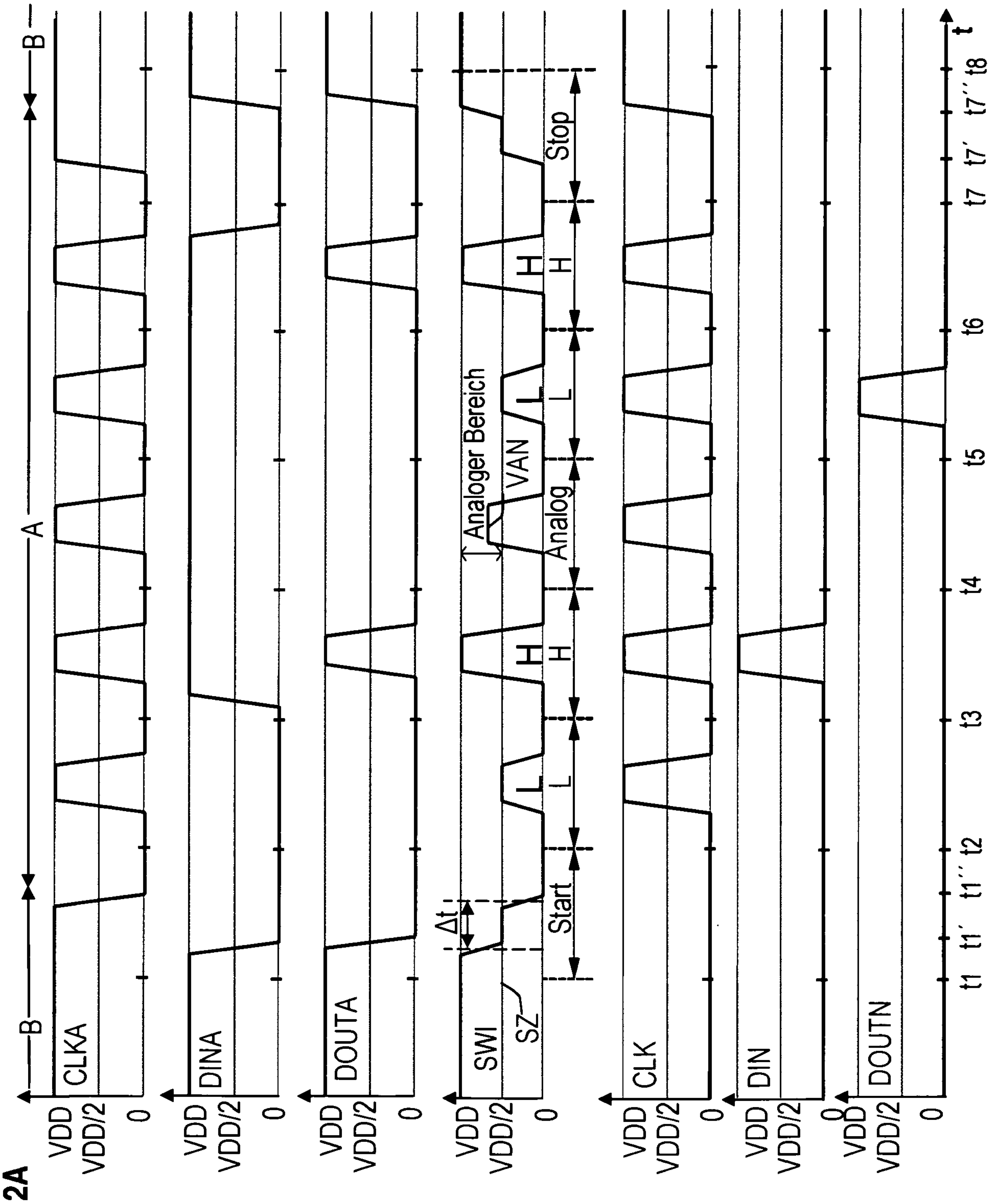

B
A
B
CLKA
DINA
DOUTA
SWI
SZ
CLK
DIN
DOUTN
VDD
VDD/2
0
Δt
Start
L
H
Analog
Analoger Bereich
VAN
Stop
t1 t1´ t1´´ t2 t3 t4 t5 t6 t7 t7´ t7´´ t8
t

FIG 2B

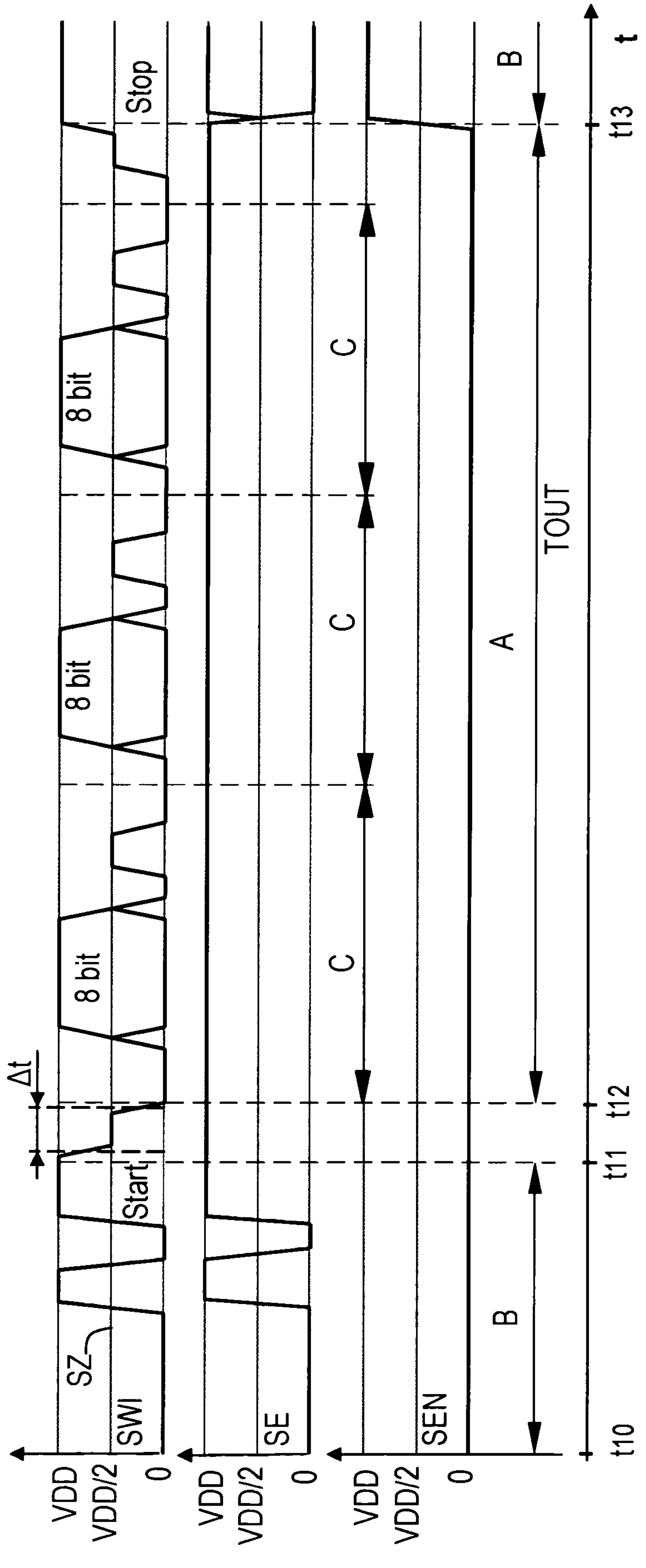
VDD
VDD/2
0
SWI
SZ
Start
Δt
8 bit
8 bit
8 bit
Stop
VDD
VDD/2
0
SE
VDD
VDD/2
0
SEN
C
C
C
B
A
B
TOUT
t10
t11
t12
t13
t

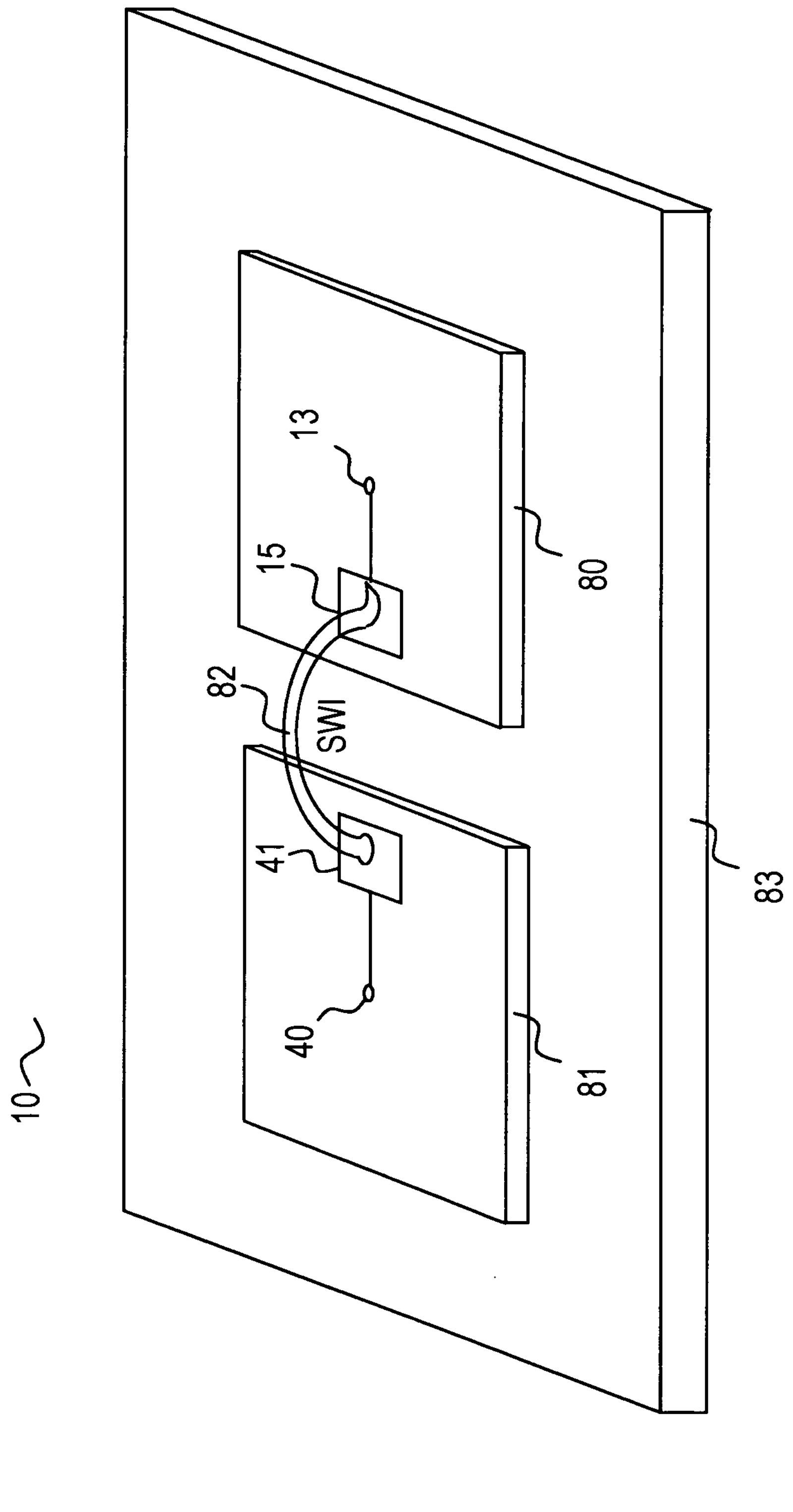


FIG 3

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- DE 102006042115 A1
- US 5881121 A
- US 7089467 B2
- US 20060087307 A1
- US 20040039963 A1
- US 20030200359 A1
- US 5473758 A